(19) Europäisches Patentamt
European Patent Office
Office européen des brevets

(11) **EP 2 165 851 A1**

(12) **EUROPEAN PATENT APPLICATION**
published in accordance with Art. 153(4) EPC

(43) Date of publication:
24.03.2010 Bulletin 2010/12

(51) Int Cl.:
*B44C 1/165* $^{(2006.01)}$      *B44C 1/17* $^{(2006.01)}$

(21) Application number: 08765578.3

(86) International application number:
PCT/JP2008/060868

(22) Date of filing: 13.06.2008

(87) International publication number:
WO 2008/153136 (18.12.2008 Gazette 2008/51)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 13.06.2007 JP 2007156038
20.07.2007 JP 2007189668

(71) Applicants:
• Toppan TDK Label Co Ltd.
Taito-ku
Tokyo 110-0016 (JP)
• Nippon Sheet Glass Co., Ltd.
Minato-ku
Tokyo 108-6321 (JP)

(72) Inventors:
• IIKUMA, Akihiro
Tokyo 110-0016 (JP)
• SHINOZAKI, Hideaki
Tokyo 110-0016 (JP)
• KIKUCHI, Masahiro
Tokyo 110-0016 (JP)
• OTSUKA, Tatsuya
Tokyo 110-0016 (JP)
• KUBO, Taiichi
Tokyo 110-0016 (JP)
• ONO, Kazuhisa
Tokyo 108-6321 (JP)

(74) Representative: Müller-Boré & Partner
Patentanwälte
Grafinger Strasse 2
81671 München (DE)

(54) **TRANSFER FILMS FOR BURNING AND METHOD OF FORMING SUBSTRATE WITH FUNCTIONAL PATTERN**

(57)      Transfer films for firing which have the excellent property of transferring a functional pattern and enable a pyrolysis gas generated by the firing of organic substances to be released smoothly, and which can form on a substrate a functional pattern free from defects such as a shape or function failure. One of the transfer films for firing comprises a release film and a multilayered structure formed so as to be in contact with one of the surfaces of the release film. The multilayered structure includes both a pressure-sensitive adhesive layer for bonding the transfer film for firing to a surface of a substrate and a functional pattern formed between the release film and the pressure-sensitive adhesive layer. The functional pattern comprises inorganic particles and a first organic substance removable by firing, and the pressure-sensitive adhesive layer comprises a second organic substance removable by firing and different from the first organic substance. The heat decomposition temperature of the first organic substance (Tdb), the heat decomposition temperature of the second organic substance (Tda), and the fusion bonding temperature of the inorganic particles (Tw) each measured under the firing conditions to be used for firing the multilayered structure transferred to a surface of a substrate satisfy the relationship Tdb.

## FIG.1

**Description**

TECHNICAL FIELD

The present invention relates to a transfer film for forming an electrically conductive pattern including a wiring circuit, electrodes, and the like or a decorative pattern, such as a pattern design, on a substrate of glass or the like, and particularly to a transfer film for firing that is suitable for a case where a laminate including a functional pattern is transferred to the substrate, and thereafter is fired.

BACKGROUND ART

Conventionally, the provision of functional patterns to substrates of glass, pottery, and the like has been performed in various fields. Examples of such provision include: formation of electrically conductive patterns, such as electric circuits, on substrates; decoration of potteries; formation of electrode patterns and ribs in plasma display panels; formation of antennas on glass plates mountable on vehicles, and the like.

As methods of forming such functional patterns, the photolithography / etching method, the screen printing method, the sputtering method and the like are widely adopted, for example. When a substrate has a smooth surface shape, the formation can be performed directly on the surface by adopting the above-described methods. However, when a substrate curves or is concavo-convex, none of the above methods can successfully be employed. For this reason, a transfer method has been examined in which a functional pattern is formed on a film in advance, and this functional pattern is transferred from the film to a substrate. With the transfer method, it is possible for the functional pattern to follow the contour of the substrate, irrespective of the dimensions and the shape of the substrate. Hence, the transfer method is excellent in patterning capability and productivity, and allows a functional pattern to be formed on any substrate at a low cost. For example, Patent Documents 1 to 5 describe such transferable films.

Patent Document 1 discloses a transfer paper for decorating potteries. In the transfer paper, plural colored layers and intermediate layers between the colored layers are sequentially formed by screen-printing on a base paper for printing, and a cover layer is provided at an uppermost part. Patent Document 3 discloses a transfer sheet for producing a plasma display panel. In the transfer sheet, a peelably provided transfer layer and a stress absorbing layer are provided on a base film, and the transfer layer contains inorganic components including glass frit and an organic component removable by firing. Here, the complex elastic modulus of the stress absorbing layer is smaller than the complex elastic modulus of the transfer layer. Patent Document 4 discloses an in-vehicle log-periodic dipole antenna in which a conductor pattern stacked on a transfer film is formed on a glass plate mountable on a vehicle by a transfer method. Patent Document 5 discloses a method for forming a pattern such as an electric circuit. This method includes forming a print pattern on a transfer film by using a glass paste, thermally transferring the print pattern onto a substrate, and firing the transferred print pattern. These include transfer films for firing with which functional patterns are formed by transfer to substrates followed by firing.

Patent Document 1: Japanese Patent Application Publication No. H05-139020
Patent Document 2: Japanese Patent Application Publication No. H11-135009
Patent Document 3: Japanese Patent Application Publication No. H11-260250
Patent Document 4: Japanese Patent Application Publication No. 2001-211020
Patent Document 5: Japanese Patent Application Publication No. 2000-151080

DISCLOSURE OF THE INVENTION

PROBLEMS TO BE SOLVED BY THE INVENTION

According to a first aspect, a laminate which is included in a transfer film for firing and which contains a functional pattern needs at least an adhesive layer to bond the functional pattern to a substrate. In addition, the laminate has a configuration in which some layers are stacked on one another, if necessary. The functional pattern contains an inorganic powder which is thermally-fusible and which gives the mechanical strength after firing, and an organic material which keeps the shape before firing and which is removed by firing. The adhesive layer is made by making the functional pattern itself contain an adhesive component, or made of an organic material which is provided separately from the functional pattern and which is decomposed and removed by firing.

When fired at high temperatures, the organic materials are pyrolyzed at their respective temperatures specific to the organic materials, and removed as pyrolysis-gases. Meanwhile, the powder surfaces of the inorganic powder in the functional pattern melt so that the particles of the inorganic powder fuse with one another, or with the substrate. However, the following failure in firing or the like occurs frequently. Specifically, since each layer other than the functional pattern contains an organic material as its main component, the generated amount of the pyrolysis-gas generated from the layer in firing is larger than that from the functional pattern. For this reason, when the release of the pyrolysis-gas is interfered because of an influence of the inorganic powder contained in the functional pattern, a fired body of a functional pattern containing bubbles may be formed, or the pressure of the pyrolysis-gas may increase, which results in fracture of the functional pattern, or peeling-off thereof from the substrate. For this reason, to form a favorable fired body of a functional pattern without defects, it is important that the pyrolysis-gases from the organic materials be released smoothly from the laminate including a functional pattern.

In this connection, according to the first aspect, an object of the present invention is to provide a transfer film for firing which is excellent in transferability of the laminate including a functional pattern, and which allows the pyrolysis-gases from the organic materials due to firing to be released smoothly, and hence which allows a fired body of a functional pattern to be formed on a substrate, without such defects as defective shape and defective function.

According to a second aspect, a laminate which is included in a transfer film for firing and which contains a functional pattern needs at least a functional pattern and an adhesive layer to bond the functional pattern to a substrate. In addition, the laminate has a configuration in which some layers are stacked on one another, if necessary. The adhesive layer is made by making the functional pattern itself contain an adhesive component, or made of an organic material which is provided separately from the functional pattern and which is decomposed and removed by firing. Meanwhile, the functional pattern at least contains an inorganic powder which is thermally-fusible and which gives the mechanical strength after firing, and an organic material which keeps the shape before firing and which is removed by firing.

When fired at high temperatures, the organic materials are pyrolyzed at their respective temperatures specific to the organic materials, and removed as pyrolysis-gases. The powder surfaces of the inorganic powder melt so that the particles of the inorganic powder fuse with one another, or with the substrate. In the transfer film for firing, the smaller amount of the organic material the functional pattern contains, the more excellent mechanical strength can be obtained after firing. Accordingly, the functional pattern can have the desired function. In addition, the smaller amount of the organic material is preferable from the viewpoint of the design of the functional pattern.

To produce the transfer film for firing, for example, a film having peelability or other films can be used as a supporting body, and the functional pattern, the adhesive layer, and the like can be formed one upon another by a method such as a printing method. In a preferable configuration, to paste the functional pattern on a surface of the substrate, the functional pattern is transferred to the surface of the substrate with the adhesive layer interposed therebetween. However, the following failure in firing or the like occurs frequently. Specifically, the adhesive layer contains an organic material as its main component, and hence the generated amount of the pyrolysis-gas generated from the adhesive layer in firing is larger than that from the functional pattern. For this reason, when the release of the pyrolysis-gas is interfered because of an influence of the inorganic powder contained in the functional pattern, a fired body of a functional pattern containing bubbles may be formed or the pressure of the pyrolysis-gas may increase, which results in fracture of the functional pattern, or peeling-off thereof from the substrate. For this reason, to form a favorable fired body of a functional pattern without defects, it is important that the pyrolysis-gas from the organic material is released smoothly from the laminate including the functional pattern.

In this connection, according to the second aspect, another object of the present invention is to provide a transfer film for firing which is excellent in transferability of the laminate including a functional pattern, and which allows the pyrolysis-gases form the organic materials by firing to be released smoothly, and hence which allows a fired body having a functional pattern to be formed on a surface of a substrate without such defects as defective shape and defective function.

MEANS FOR SOLVING THE PROBLEMS

The present invention is, in a first aspect, a transfer film for firing used for forming a fired body of a functional pattern by transferring a laminate including the functional pattern to a surface of a substrate, followed by firing, in which the transfer film for firing includes: a peelable film; and the laminate formed so as to be in contact with one surface of the peelable film, the laminate further includes: a sticking layer for pasting the transfer film for firing on the surface of the substrate; and a functional pattern formed between the peelable film and the sticking layer, the functional pattern contains an inorganic powder and a first organic material removable by firing, and the sticking layer contains a second organic material which is removable by firing and different from the first organic material.

According to the transfer film for firing of the present invention, pressure is applied on and through the peelable film to thereby paste the functional pattern on the substrate. Thereafter, the peelable film is peeled off, and the functional pattern and the sticking layer are simultaneously fired to decompose and remove unnecessary organic materials and to provide the functional pattern onto the substrate.

Furthermore, the transfer film for firing according to the present invention is a transfer film for firing **characterized in that**, under a firing condition for firing the laminate transferred to the surface of the substrate, a pyrolysis temperature (Tdb) of the first organic material, a pyrolysis temperature (Tda) of the second organic material, and a fusion temperature

(Tw) of the inorganic powder satisfy a relation of: Tdb < Tda < Tw.

According to one embodiment of the present invention, the laminate includes an intermediate layer formed between the functional pattern and the sticking layer.

The one embodiment of the present invention is **characterized in that**, under the firing condition, the pyrolysis temperature (Tdb) of the first organic material, a pyrolysis temperature (Tdm) of the second organic material, the pyrolysis temperature (Tda) of the organic material contained in the sticking layer, and the fusion temperature (Tw) of the inorganic powder satisfy a relation of: Tdb < Tdm < Tda < Tw.

According to one other embodiment of the present invention, the laminate includes a protective layer which protects the functional pattern and which is formed between the peelable film and the functional pattern, and the protective layer contains a third organic material which is removable by firing and different from the first organic material.

The one other embodiment of the present invention is **characterized in that**, under the firing condition, a pyrolysis temperature (Tdp) of the third organic material and the pyrolysis temperature (Tdb) of the first organic material satisfy a relation of: Tdp < Tdb.

According to still one other embodiment of the present invention, under the firing condition, a maximum value of a generation rate of a pyrolysis gas from the organic material contained in the sticking layer is less than 5 wt%/sec, based on an initial mass of the organic material contained in the sticking layer.

The present invention is also a method of forming a substrate with a functional pattern by transferring a laminate including the functional pattern to a surface of a substrate, followed by firing. The method is characterized by including: pasting the transfer film for firing on a surface of the substrate with the sticking layer interposed therebetween and then peeling off the peelable film of the transfer film for firing, thereby forming a substrate to which the laminate including the functional pattern is transferred; and firing the substrate to which the laminate is transferred under such a firing condition that the organic materials contained in the laminate are pyrolyzed sequentially in order from the farthest organic material from the surface of the substrate.

According to one embodiment of the present invention, the firing condition is such that a maximum value of a generation rate of a pyrolysis gas from the organic material contained in the sticking layer is less than 5 wt%/sec, based on an initial mass of the organic material contained in the sticking layer.

The present invention is, in a second aspect, a transfer film for firing used for forming a fired body of a functional pattern by transferring a laminate including the functional pattern to a surface of a substrate, followed by firing, in which the transfer film for firing includes: a peelable film; and the laminate formed on the peelable film, the laminate includes: a functional pattern; and at least one adhesive layer which is bonded to the surface of the substrate when the laminate is transferred to the substrate, the functional pattern contains an inorganic powder and an organic material removable by firing, the adhesive layer contains an organic material removable by firing, and a pyrolysis completion temperature of the organic material contained in the adhesive layer located between the functional pattern and the peelable film is lower than a pyrolysis completion temperature of the organic material contained in the functional pattern.

According to one embodiment of the present invention, one of a glass transition temperature and a softening temperature of the organic material contained in the adhesive layer is 50˚C or above but 150˚C or below.

The present invention is also a method of forming a substrate with a functional pattern by transferring a laminate to a surface of a substrate, followed by firing, the method including: pasting the transfer film for firing on the surface of the substrate with the adhesive layer interposed therebetween and then peeling off the peelable film of the transfer film for firing, thereby forming a substrate to which the laminate including the functional pattern is transferred, and firing the substrate to which the laminate is transferred, under such a firing condition that, after the pyrolysis of the organic material contained in the adhesive layer is completed, the pyrolysis of the organic material contained in the functional pattern is completed.

Furthermore, the present invention is a method of forming a substrate with a functional pattern by transferring a laminate to a surface of a substrate, followed by firing, the method including: heating the transfer film for firing to a temperature which is not less than a glass transition temperature or a softening temperature of the organic material contained in the adhesive layer; pasting the heated transfer film for firing on the surface of the substrate in a way that the functional pattern comes into contact with the substrate and then peeling off the peelable film of the transfer film for firing, thereby forming a substrate to which the laminate including the functional pattern is transferred; and firing the substrate to which the laminate is transferred, under such a firing condition that, after the pyrolysis of the organic material contained in the adhesive layer is completed, the pyrolysis of the organic material contained in the functional pattern is completed.

According to one embodiment of the present invention, the temperature to which the transfer film for firing is heated is 50˚C or above but 150˚C or below.

EFFECTS OF THE INVENTION

In the transfer film for firing according to the first aspect of the present invention, the pyrolysis temperature of an organic material contained in an upper layer is made lower than that in an lower layer at the time of firing of the laminate including a functional pattern transferred onto the substrate, and the fusion temperature of the inorganic powder is made higher than the pyrolysis temperatures of all the organic materials. Thereby, the pyrolysis-gases from the organic materials are released in a favorable manner. This makes it possible to form a functional pattern without such defects as defective shape and defective function on the substrate. Moreover, the above-described effect can be enhanced by controlling the pyrolysis-gas generation rate from the organic material contained in the sticking layer so that the maximum value of the generation rate becomes less than 5 wt%/sec.

The transfer film for firing according to the second aspect of the present invention allows the transfer without the adhesive layer interposed between the substrate and the functional pattern, because the laminate including a functional pattern is transferred onto the surface of the substrate with the adhesive layer covering the functional pattern. As a result, even when the adhesive layer and the functional pattern are simultaneously fired, the pyrolysis-gas generated from the adhesive layer exerts no influence. Accordingly, it is possible to eliminate failure in firing such as formation of a functional pattern containing bubbles, or fracture of the functional pattern or peeling-off thereof from the substrate due to the increase in pressure of the pyrolysis-gas. Moreover, the pyrolysis completion temperature of the organic material contained in the adhesive layer is lower than the pyrolysis completion temperature of the organic material contained in the functional pattern, making it possible to facilitate the release of the pyrolysis-gas from the organic material contained in the functional pattern. Moreover, the glass transition temperature or the softening temperature of the organic material contained in the adhesive layer is 50˚C or above but 150˚C or below. As a result, the transfer on the surface of the substrate can be easily performed by applying pressure and heat, thereby improving the transferability (adhesiveness) to the surface of the substrate.

Moreover, according to the method of forming a substrate with a functional pattern of the present invention, by setting the firing condition as appropriate, the adhesive layer is first pyrolyzed, and then the organic material contained in the functional pattern is pyrolyzed. Thereby, the decomposition gas due to the pyrolysis of the organic material is released in a favorable manner. As a result, it is possible to form a functional pattern without such defects as defective shape and defective function on the substrate.

Moreover, according to the method of forming a substrate with a functional pattern of the present invention, when the laminate including the functional pattern is formed on the substrate by transfer, application of pressure and heat through the peelable film softens the adhesive layer, making it possible to easily bond the adhesive layer to the substrate.

Note that, in the method of forming a substrate with a functional pattern of the present invention, even when a peelable film used is a film of a plastic such as polyester, by setting the temperature to which the transfer film for firing is heated to 50˚C or above but 150˚C or below, the thermal deformation and the like of the film are less likely to occur at the time of the transfer, thereby making it possible to reduce the damage on the functional pattern.

BEST MODES FOR CARRYING OUT THE INVENTION

First, regarding the first aspect, the present invention will be described in detail below.

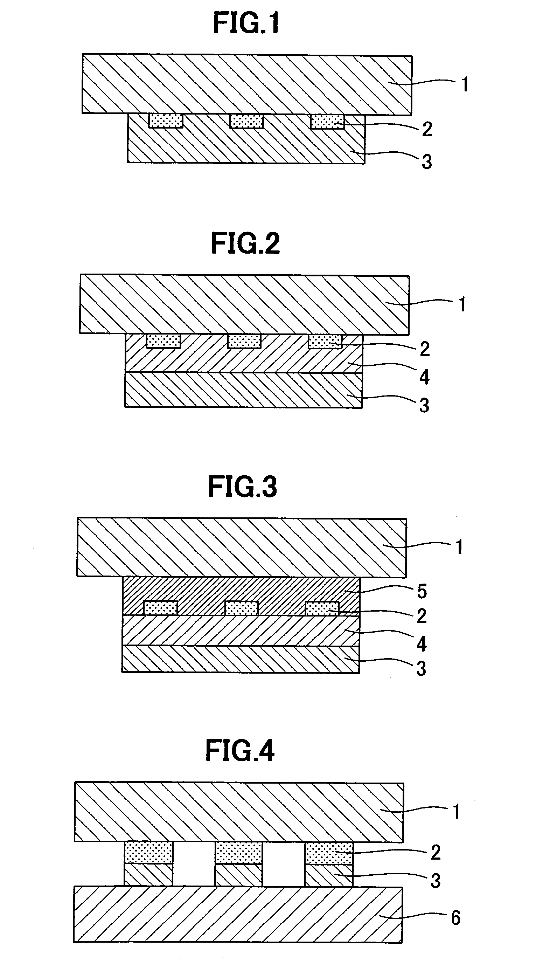

Fig. 1 is an enlarged schematic sectional diagram illustrating a structure of a transfer film for firing, which is one embodiment of the present invention. In a configuration according to this embodiment of the present invention, a peelable film 1, a functional pattern 2 provided on a peelable film 1 and containing an inorganic powder and an organic material removable by firing, and a sticking layer 3 formed of an organic material removable by firing are provided. This configuration allows a fired body of the functional pattern to be formed on a substrate as follows. Specifically, the transfer film for firing is pasted on a substrate (not shown) by the sticking layer 3. Thereafter, the peelable film 1 is peeled off, and the substrate to which the laminate including the functional pattern sticks is fired to decompose and remove the organic materials. Fig. 2 is an enlarged schematic sectional diagram illustrating a structure further including an intermediate layer 4 which is located between the functional pattern 2 and the sticking layer 3 and which is made of an organic material removable by firing. Fig. 3 is an enlarged schematic sectional diagram illustrating a structure further including a protective layer 5 which is located between the functional pattern 2 and the peelable film 1, and which is made of an organic material removable by firing.

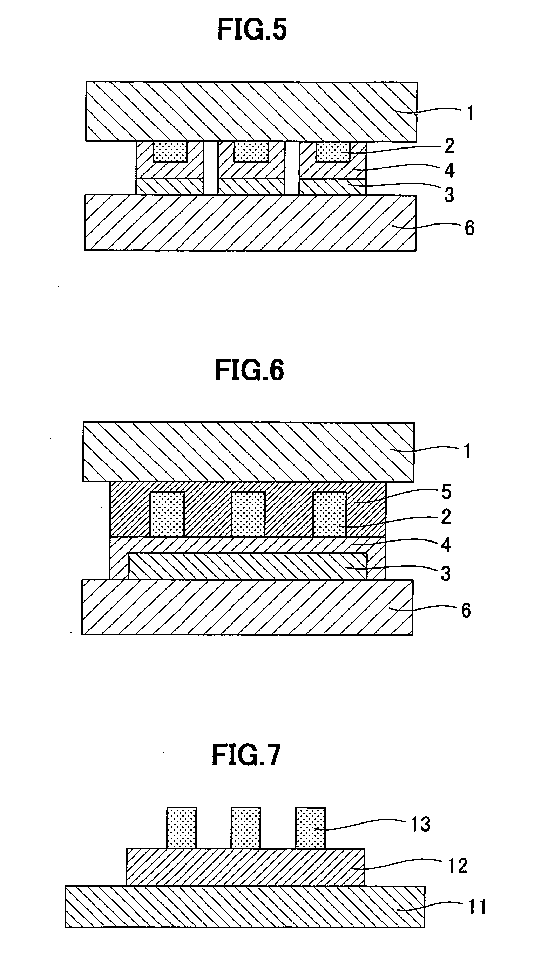

The peelable film has only to be peelable from the laminate including the functional pattern. A film base material can be used without any modification. If necessary, a configuration may be employed in which a peelable layer of a silicone-based or alkyd resin-based material or the like or a weakly sticking layer having removability is formed on the film base material. Moreover, in another configuration which may be employed, the peelable film 1 is termed as a first peelable film 1, a second peelable film 6 is pasted on a sticking layer surface of the laminate including a functional pattern, and the laminate including the functional pattern is sandwiched and held between the two peelable films. Fig. 4 is an enlarged schematic sectional diagram illustrating a structure in which a laminate formed of the functional pattern 2 and the sticking layer 3 is provided between the first peelable film 1 and the second peelable film 6. Fig. 5 is an enlarged schematic sectional diagram illustrating a structure further including an intermediate layer 4 between the functional pattern 2 and the sticking layer 3. Fig. 6 is an enlarged schematic sectional diagram illustrating a structure further including a protective layer 5 between the functional pattern 2 and the first peelable film 1. In these cases, the peel load on the first peelable film 1 side needs to be smaller than the peel load on the second peelable film 6 side. The bonding strength at each of the delamination interfaces is adjustable by the kinds or film thickness of the base material and the peelable layer, and the like.

As the base material for the peelable films, a flexible base material is preferable in view of workability in transfer. For example, a plastic such as polyethylene, polyimide, polyethylene terephthalate, or acrylic, as well as paper, or the like can be used as the base material. The thickness of the base material is not particularly limited, and an optimal thickness may be determined in consideration of a balance among the pressure at the time of the transfer, the thermal conductivity and the flexibility of the film. Accordingly, the thickness which is suitably employed from the viewpoint of production or working is 2 $\mu$m 5 to 250 $\mu$m, preferably 35 $\mu$m to 125 $\mu$m, and further preferably 50 $\mu$m to 75 $\mu$m.

The peelable film also serves as a supporting body when the functional pattern and the sticking layer, and further the intermediate layer and the protective layer, which form the laminate including the functional pattern, are formed by a printing method or the like.

As a method of forming the functional pattern or each of the layers on the peelable film, a printing method such as the screen printing or the offset printing, or a coating method such as the gravure coating can be used. When a pattern is formed, the printing method is preferably used. When a layer is formed uniformly over a wide area, the coating method, as well as the printing method, is preferably used.

When the functional pattern or each of the layers is formed by the printing method or the coating method, a coating liquid (paste) to be used is prepared by dispersing or dissolving, into a solvent, the corresponding one(s) of the inorganic powder and the organic material to be contained in the functional pattern or the layer. The solvent is selected by taking account of the solubilities and the dispersibilities of the inorganic powder and the organic material and the boiling point that is appropriate for the printing process. Some examples of such usable solvents are: water-based solvents; alcohol-based solvents; ketone-based solvents; ester-based solvents; ether-based solvents and hydrocarbon-based solvents. These solvents can be used alone or as a mixture. Before use, the viscosity, the thixotropy, and other properties of the solvent are adjusted appropriately for the printing process. The solid content of the solvent is also adjusted before use. Most of each of the solvents vaporizes after the printing or the coating of the functional pattern. The remaining part of the solvent is removed by vaporization or decomposition by firing.

If necessary, additives such as a defoamer to serve as countermeasures against bubbles formed at the time of printing, and a thickener to adjust the viscosity may be used. As such an additive, one decomposable and removable by firing is used.

The functional pattern contains an inorganic powder which mainly functions to exhibit the mechanical strength after firing and which is thermally fusible to the substrate, another inorganic powder which is a functional material of various kinds corresponding to the desired functions to be obtained after firing, and an organic material which maintains the shape before firing, and which is removed by firing.

As the inorganic powder which is thermally fusible, a material such as glass frit can be used for the purposes of, for example, making the substrate support the functional materials of various kinds after firing and improving the durability. A glass frit of an appropriate composition may be selected in consideration of the balance among such factors as the firing temperature and the thermal shrinkage ratio.

The functional materials should be selected, as appropriate, for use, so as to correspond to the desired functions to be obtained after firing. For example, for wiring, electrodes, or the like, powders of Au, Ag, Cu, Ni, Co, Sn, Pb, Zn, Bi, and In, as well as powders of alloys containing above-mentioned metals can be used. Some examples of the materials used as dielectrics such as capacitor parts or as highly-resistive parts are powders of BaTiO, SiC, $TiO_2$, $SiO_2$ RuO, and the like.

The organic material is not particularly limited, as long as the material is removable by firing. Some examples of the material which is easily removed by pyrolysis by firing are such resins as acrylic, methylcellulose, nitrocellulose, ethylcellulose, vinyl acetate, polyvinyl butyral, polyvinyl acetal, polyvinyl alcohol, polyethylene oxide, and polyester. These resins can be used alone or as a mixture. In addition, as an organic component, a plasticizer may be added for the purpose of giving flexibility to the coating film before firing. As the plasticizer, one selected as appropriate from fatty-acid esters, phosphate esters, and the like can be used.

Either a single functional pattern or plural functional patterns are provided. The plural patterns may be stacked, or may be arranged side by side. The film thickness of each functional pattern is determined appropriately for the function to be obtained.

The sticking layer is not particularly limited, as long as the sticking layer is made of an organic material which is removable by firing. Any sticking agent that is sticky at normal temperature, such as an acryl-based sticking agent or a rubber-based sticking agent, can be used for the sticking layer. The sticking layer may be formed so as to cover entirely the supporting body such as the peelable film; alternatively, the sticking layer may be formed on the functional pattern in a pattern similar to the functional pattern.

The film thickness of the sticking layer is from 1 μm to 20 μm, and is preferably from 2 μm to 10 μm. A film thickness that is smaller than 1 μm makes the sticking performance so insufficient that transferability becomes poor. A film thickness that is larger than 20 μm results in so large a pyrolysis-gas generation amount that the functional pattern is more likely to have some defects and to result in failure in firing. The film thickness of the sticking layer is preferably as thin as possible as long as the necessary sticking performance is maintained.

In the present invention, the intermediate layer may be provided between the functional pattern and the sticking layer. The intermediate layer serves as a barrier for preventing the solvent and the organic material contained in the sticking agent used for formation of the sticking layer from permeating into the functional pattern.

The intermediate layer is not particularly limited as long as the intermediate layer is made of an organic material which is removable by firing. The organic material for the intermediate layer may be selected from those similar to the organic materials used for the functional pattern. In particular, a polymer resin having a glass-transition temperature of 50°C or above is preferable because of its high barrier effect.

The intermediate layer may be formed so as to cover entirely the supporting body such as the peelable film; alternatively, the intermediate layer may be formed on the functional pattern in a pattern similar to the functional pattern. With a film thickness of 0.5 μm or larger, the intermediate layer has barrier effects; however, the intermediate layer preferably needs to have a film thickness of 1 μm or more. A thicker intermediate layer results in so large a pyrolysis-gas generation amount that the functional pattern is more likely to have some defects and to result in failure in firing. For these reasons, the film thickness of the intermediate layer is preferably made as thin as possible so as to be 10 μm or smaller, and more preferably 5 μm or smaller.

The protective layer has a role of protecting the functional pattern which has been transferred to the substrate but is yet-to be fired against the attaching of foreign objects and against scars. The functional pattern has only a small proportion of the organic-material content, and thus tends to have a hard and brittle film property before firing. Hence, if the transfer film is bent, cracks are likely to be formed in the functional pattern. Under such a circumstance, the protective layer also has a role of preventing cracks and the like from being formed when the film is bent. The protective layer is not particularly limited as long as the protective layer is made of an organic material which is removable by firing. The organic material may be selected from those similar to the organic materials used for the functional pattern.

The protective layer may be formed so as to cover the functional pattern; alternatively, the protective layer may be formed in a similar pattern shape to the functional pattern. The film thickness of the protective layer is preferably 0.1 μm to 2 μm.

According to the embodiment of the present invention, the functional pattern is sandwiched and held between the protective layer and the intermediate layer, and hence has an improved bendability, providing a high workability in the pasting to or the transferring to the substrate. Moreover, since the protective layer and the intermediate layer cover the sticking layer, the sticking layer is not exposed to the outside after transfer, thereby making it possible to prevent attachment of foreign objects to the sticking layer due to a strong stickiness. Even in a case where the functional pattern is thin wires, dots, or the like, when the protective layer, the intermediate layer, and the sticking layer are formed all over the surface of the supporting body, the contact surface with the substrate can be widen, irrespective of the pattern shape and the size of the functional pattern, and hence the adhesiveness is sufficiently maintained. Moreover, there are advantages that plural functional patterns can be transferred at once, and that the accuracy of position is also improved, and other advantages.

Next, description will be made of the fact that the laminate which includes the functional pattern and which is transferred onto the surface of the substrate by using the transfer film for firing of the present invention exhibits excellent property in firing.

In the functional pattern, it is necessary that the organic material be pyrolyzed by firing and removed, and then the inorganic powder fuse to form a pattern. When exposed to a high temperature, the organic material is pyrolyzed at a temperature specific to the organic material, and removed as a pyrolysis-gas. Then, the inorganic powder, such as glass frit or a functional material, contained in the functional pattern melts so that the molten particles of the powder fuse with one another, and the molten particles of the powder fuse with the substrate (at this time, since the functional material is held in a molten material such as the glass frit, the functional material does not necessarily have to melt). Suppose a case where the laminate including the functional pattern to be fired is a film in which the protective layer, the functional pattern, the intermediate layer, and the sticking layer are stacked on the substrate in this sequence from the upper layer, and the film is fired. In such a case, to have the pyrolysis temperatures of the organic materials become lower from lower layer to upper layer with respect to the substrate, the release of the pyrolysis-gases from the lower layers is facilitated. As a result, it is possible to form a functional pattern on the substrate, without such defects as a defective shape including bubble-like chipping or peeling-off from the substrate, and defective function accompanying the defective shape occurring in the functional pattern.

For this reason, in the transfer film for firing of the present invention, the pyrolysis temperature (Tda) of the organic material in the sticking layer, the pyrolysis temperature (Tdb) of the organic material in the functional pattern layer, and the fusion temperature (Tw) of the inorganic powder need to satisfy the relation of: Tdb < Tda < Tw. Meanwhile, when the intermediate layer is provided between the functional pattern and the sticking layer, the pyrolysis temperature (Tdm) of the organic material in the intermediate layer needs to satisfy the relation of Tdb < Tdm < Tda < Tw. When the inorganic powder includes plural kinds of powders, the lowest fusion temperature is taken as the fusion temperature (Tw) of the inorganic powder in the above relational expression.

In particular, the sticking layer is located at a position in contact with the substrate, in other words, located as the lowermost layer, and has a relatively large film thickness. Hence, the pyrolysis-gas is generated from the sticking layer in a large quantity, and is difficult to release. In addition, if the rate of temperature increase at the time of firing is fast, the amount of the pyrolysis-gas per unit time becomes large, and also the decomposition temperature shifts to the high-temperature side. For this reason, to obtain a favorable fired film, the maximum pyrolysis-gas rate of the sticking layer needs to be 5 wt%/sec or less, and preferably 3 wt %/sec or less, based on the initial weight of the organic material contained in the sticking layer.

Here, as the pyrolysis temperature, used is a temperature at which the differential value of the weight change curve reaches its maximum in a thermogravimetry analysis in which the temperature is raised in accordance with the same temperature raising program as in the case of actual firing in a firing furnace. The pyrolysis-gas generation rate is represented as a decomposition weight percentage per unit time at the temperature at which the differential value of the weight change curve reaches its maximum, based on the initial weight of the organic material decomposed. Here, the pyrolysis-gas generation rate is represented by the unit of wt%/sec. For the thermal fusion temperature of the inorganic powder, the temperature of the fuse is determined from the results of observing the film surface when the firing is performed in accordance with the temperature raising program.

When the protective layer is provided on the opposite side to the sticking layer of the functional pattern, the pyrolysis temperature (Tdp) of the organic material contained in the protective layer needs to be lower than the pyrolysis temperature (Tdb) of the organic material contained in the functional pattern (Tdp < Tdb).

The protective layer is formed as an upper layer on the functional pattern, and serves as the uppermost layer of the laminate. Hence, when the relation: Tdp < Tdb holds, a favorable fired film can be formed. Even when the relation of: Tdp > Tdm holds, if the film thickness is within the range from 0.1 $\mu$m to 2 $\mu$m, the pyrolysis-gas from the lower layer can pass through the film of the protective layer which is partially decomposed and be released. Hence, a favorable fired film can be formed. However, when the relation of: Tdp > Tdm holds and the film thickness of the protective layer is larger than 2 $\mu$m, failure in firing is more likely to occur because of the release of the pyrolysis-gas from the lower layer.

Next, regarding the second aspect, the present invention will be described in detail.

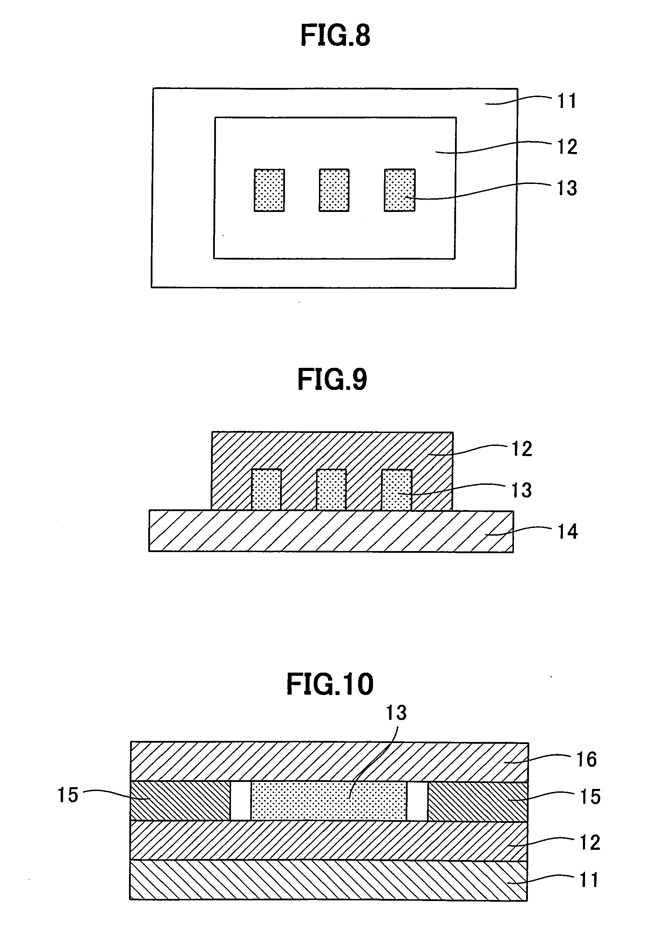

Fig. 7 is an enlarged schematic sectional diagram illustrating the structure of a transfer film for firing which is another embodiment of the present invention, and Fig. 8 is a schematic plan diagram. The transfer film for firing has a configuration in which an adhesive layer 12 and a functional pattern 13 are provided on a peelable film 11 in this order, and in which the area of the adhesive layer 12 is wider than that of the functional pattern 13. Fig. 9 is an enlarged schematic sectional diagram of the laminate, of the transfer film for firing, including the adhesive layer 12 and the functional pattern 13 and transferred to a surface of a substrate 14 (hereinafter, simply referred to as the substrate). The transfer film for firing is bonded to the substrate 14, so that the adhesive layer 12 covers the functional pattern 13. Then, the peelable film 11 is peeled off, and the adhesive layer 12 and the functional pattern 13 are simultaneously fired. Thus, a fired body of the functional pattern can be provided to the substrate 14.

According to the present invention, since covered with the adhesive layer 12 and not exposed to the outside, the functional pattern 13 after transfer is physically protected from scars and external pressure before firing, and has an excellent reliability. In addition, even when the functional pattern is thin wires, a dot pattern, or the like, by increasing the area of the adhesive layer, the contact area with the peelable film and the substrate becomes large. As a result, pattern defects such as chipping and falling-off are less likely to occur at the time of peeling-off from the peelable film. In addition, the adhesiveness to the substrate can be sufficiently maintained.

The peelable film has only: to allow the laminate including the functional pattern to be formed in producing the transfer film for firing of the present invention; and to be peelable when the laminate including the functional pattern is formed on the substrate by transfer. In particular, in consideration of the workability at the time of transfer, a flexible film base material is preferable as the peelable film. For example a plastic such as polyethylene, polyimide, polyethylene terephthalate, or acrylic, as well as paper, or the like can be used as the base material. The thickness of the base material is not particularly limited, and an optimal thickness may by determined in consideration of a balance among the pressure at the time of the transfer, the thermal conductivity and the flexibility of the film. The thickness which is suitably employed from the viewpoint of production or working is 25 $\mu$m to 250 $\mu$m, preferably 35 $\mu$m to 125 $\mu$m, and further preferably 50 $\mu$m to 75 $\mu$m.

The peelable film serves as a supporting body when the adhesive layer and the functional pattern, which form the laminate including a functional pattern, are formed by a printing method or the like. The peelable film also serves as a protective film when the laminate including the functional pattern is transferred to the substrate.

The above-described base material can be used as the peelable film without any modification. Alternatively, to facilitate the peeling-off when the laminate including the functional pattern is transferred to the substrate, a peelable layer of silicone or the like or a weakly sticking layer may be formed on the film base material.

As a method of forming the adhesive layer or the functional pattern on the peelable film, a printing method such as the screen printing or the offset printing, or a coating method such as the gravure coating can be used. When a pattern is formed the printing method is preferably used. When a layer is formed uniformly over a wide area as in the case of the adhesive layer, the coating method, as well as the printing method, is preferably used.

When the functional pattern or the adhesive layer is formed by the printing method or the coating method, a coating liquid (a paste) to be used is prepared by dispersing or dissolving, into a solvent, the corresponding one(s) of the inorganic powder and the organic material to be contained in the functional pattern or the adhesive layer. The solvent is selected by taking account of the solubilities and the dispersibilities of the inorganic powder and the organic material and the boiling point that is appropriate for the printing process. Some examples of such usable solvents are: water-based solvents; alcohol-based solvents; ketone-based solvents; ester-based solvents; ether-based solvents and hydrocarbon-based solvents. These solvents can be used alone or as a mixture. Before use, the viscosity, the thixotropy, and other properties of the solvent are adjusted appropriately for the printing process. The solid content of the solvent is also adjusted before use. Most of each of the solvents vaporizes after the printing or the coating of the functional pattern. The remaining part of the solvent is removed by vaporization or decomposition by firing.

If necessary, additives such as a defoamer to serve as countermeasures against bubbles formed at the time of printing, and a thickener to adjust the viscosity may be used. As such an additive, one decomposable and removable by firing is used.

The adhesive layer has a role of bonding the laminate including the functional pattern on the substrate, and another role of protecting the functional pattern after transfer. Some examples useable for the adhesive layer are such resins as acrylic, methylcellulose, nitrocellulose, ethylcellulose, vinyl acetate, polyvinyl butyral, polyvinyl acetal, polyvinyl alcohol, and polyester. These resins may be used alone, or as a mixture thereof. In addition, a plasticizer may be added for the purpose of giving adhesiveness and flexibility. As the plasticizer, a fatty-acid ester-based plasticizer, a phosphate ester-based plasticizer, or the like can be used. In a case where an organic material which is not sticky at normal temperature is used for the adhesive layer, even if dust or the like attaches to the adhesive layer in the duration from the peeling-off of the peelable film to the firing, the dust or the like can be removed easily by blowing air or the like to the adhesive layer.

The adhesive layer is preferably formed over a wide area so as to cover the functional pattern. In a case where the functional pattern includes plural patterns, or other cases, this allows the transfer to be performed easily without disturbing the positional relation among the patterns. For this reason, the adhesive layer may be formed so as to cover all over the surface of the peelable film.

The film thickness of the adhesive layer is from 1 $\mu$m to 20 $\mu$m, and is preferably from 2 $\mu$m to 10 $\mu$m. A film thickness that is smaller than 1 $\mu$m makes the adhesive performance so insufficient that transferability becomes poor. A film thickness that is larger than 20 $\mu$m results in so large a pyrolysis-gas generation amount that the firing furnace is contaminated, and that the firing ability of the functional pattern deteriorates. Hence, the film thickness of the adhesive layer is preferably made as thin as possible as long as the necessary adhesive performance is maintained.

The functional pattern contains an inorganic powder which mainly functions to exhibit the mechanical strength after firing and which is thermally fusible, an organic material which maintains the shape before firing and which is removed by firing, and various functional materials corresponding to the desired functions to be obtained after firing.

Either a single functional pattern or plural functional patterns are provided. The plural patterns or functional patterns different from one another may be stacked, or may be arranged side by side.

As the inorganic powder which is thermally fusible, a material such as glass frit can be used for the purposes of, for example, making the substrate support the functional materials of various kinds after firing and improving the durability. The composition of the glass frit may be determined in consideration of the balance among the firing temperature, the thermal shrinkage ratio, and the like.

The organic material is not limited to certain kinds as long as a material removable by firing is used for the organic material. Some examples of the material which is easily removed by pyrolysis by firing are such resins as acrylic, methylcellulose, nitrocellulose, ethylcellulose, vinyl acetate, polyvinyl butyral, polyvinyl acetal, polyvinyl alcohol, polyethylene oxide, and polyester. These resins can be used alone or as a mixture. In addition, a plasticizer may be added for the purpose of giving flexibility to the functional pattern before firing. As the plasticizer, a fatty-acid ester-based plasticizer, a phosphate ester-based plasticizer, or the like can be used.

The functional materials should be selected, as appropriate, for use so as to correspond to the desired functions to be obtained after firing. For example, for wiring, electrodes, or the like, powders of Au, Ag, Cu, Ni, Co, Sn, Pb, Zn, Bi, and In, as well as powders of alloys containing above-mentioned metals can be used. Some examples of the materials used as dielectrics such as capacitor parts or as highly-resistive parts are powders of BaTiO, SiC, $TiO_2$, $SiO_2$, RuO, and the like.

When the laminate including the functional pattern is transferred to the substrate by using the transfer film for firing of the present invention, the adhesive layer is formed so as to cover the functional pattern (Fig. 9). For this reason, the organic materials are selected so that the pyrolysis completion temperature of the organic material contained in the adhesive layer may be lower than the pyrolysis completion temperature of the organic material contained in the functional pattern. When the laminate including the functional pattern is fired, it is preferable that, first, the adhesive layer be pyrolyzed, subsequently the adhesive layer is entirely pyrolyzed, and then the organic material contained in the functional pattern starts to be pyrolyzed. However, in some case where the adhesive layer has certain pyrolysis characteristics, the organic material contained in the functional pattern may start to be pyrolyzed, before the adhesive layer completely disappears. Even in such case, the adhesive layer reaches a state where the film is sparse because of the release of the pyrolysis-gas, and the release paths (pores) for the pyrolysis-gases are formed. In addition, as the firing temperature increases, the decomposition of the organic material contained in the adhesive layer proceeds, which increases the porosity. Thus, the pyrolysis-gas generated from the functional pattern is released, while passing through the pores in the adhesive layer, which is an upper layer. Thereafter, by further heating, particles of the inorganic powder in the functional pattern fuse with one another, and simultaneously the substrate and the inorganic powder fuse with each other. Thus, the fired body of the functional pattern is formed.

When the pyrolysis completion temperature of the adhesive layer is higher than the pyrolysis completion temperature of the organic material contained in the functional pattern, a phenomenon is more likely to occur in which the pyrolysis-gas from the functional pattern entrapped by the adhesive layer increases the internal pressure, which results in cracking of the functional pattern, and hence fracture thereof. The glass transition temperature or the softening temperature of the adhesive layer is preferably 50˚C or above but 150˚C or below, in order to soften the adhesive layer by applying pressure and heat thorough the peelable film at the time of transfer, and thereby to bond the adhesive layer to the substrate so as to cover the functional pattern.

Another configuration of the transfer film for firing of the present invention includes two adhesive layers (a first adhesive layer and a second adhesive layer). The second adhesive layer is formed on the first adhesive layer except the part thereof where the functional pattern is provided, so that no difference in level exists between the functional pattern and the adhesive layer (Fig. 10). This case is **characterized in that** the second adhesive layer is formed of an organic material removable by firing, and that the pyrolysis completion temperature of the first adhesive layer is equal to or lower than the pyrolysis completion temperature of the second adhesive layer. The first adhesive layer and the second adhesive layer may be formed of the same organic material, or different organic materials.

When the second adhesive layer is formed of an organic material which is sticky at normal temperature, the laminate including the functional pattern can be bonded to the substrate without heating, i.e., at normal temperature, and thereby the workability in the transfer is facilitated. As the organic material sticky at normal temperature and removable by firing, an acrylic-based, or rubber-based sticking agent can be used.

In the transfer film for firing of the present invention, a second peelable film provided with a peelable layer of a silicone or alkyd resin or the like or a weakly sticking layer can be provided on the opposite side of the laminate, in addition to the (first) peelable film which serves as a supporting body and as a protective film for the laminate including the functional pattern. In particular, when the laminate includes a second adhesive layer which is sticky at normal temperature, the second adhesive layer can be protected from being brought in contact with other substances at the time of storage of the transfer film for firing. Since the second peelable film side of the laminate sticks to the substrate, both the adhesive performance between the second peelable film and the second adhesive layer, and the adhesiveness between the second peelable film and the functional pattern are preferably set lower than the adhesive performance between the first peelable film and the first adhesive layer.

The transfer film for firing of the present invention is produced by sequentially forming the adhesive layer and the functional pattern into a stack on the peelable film. However, depending on the method or conditions of forming the functional pattern, the surface (transfer surface) of the adhesive layer may be coarsened, and hence the adhesiveness to the substrate may be lowered. When the functional pattern is formed on the adhesive layer, the adhesive layer and the functional pattern may dissolve with each other, resulting in inability to form a favorable laminate film, depending on the combination of the organic materials and the solvents contained in the adhesive layer and the functional pattern. In such a case, the adhesive layer is formed on the (first) peelable film which serves as the supporting body, and separately, the functional pattern is formed on a second peelable film with a smooth surface. After the solvents contained in the adhesive layer and the functional pattern vaporize sufficiently, the surfaces of the formation of the films are faced to each other, and pasted with each other by heat and pressure. Thus, the transfer film can be produced. With this production method, the adhesive layer is not dissolved in the solvent. Moreover, in the functional pattern formed on the smooth peelable film, the surface which is in contact with the substrate has a favorable smoothness, which depends on the smoothness of the peelable film, and the close-contact properties and the adhesiveness to the substrate after the firing can be improved.

EXAMPLES

First, regarding the first aspect, specific examples of the present invention will be described below. The present invention is not limited to these examples.

(Example 1)

(Fabrication of Transfer Film for Firing)

A transfer film for firing described was fabricated by the following procedure.

As the peelable film, a PET film including a silicone-based mold-release layer "A70" (manufactured by Teijin DuPont Films Japan Limited, film size: 20 cm × 30 cm, thickness: 50 μm) was prepared.

As the coating liquid for the functional pattern, an electro-conductive paste was prepared on the basis of the composition shown in Table 1, by using a three-roll mill.

Next, if necessary, a drying process is performed by using an oven, a hot-air drying_furnace, or an IR drying machine, or the like. For example, drying can be performed in an oven at 120°C for 10 minutes.

As the coating liquid for the sticking layer, a sticking layer paste was prepared by replacing the solvent in an acrylic-based sticking agent "SK1451" (manufactured by Soken Chemical & Engineering Co., Ltd.) with Solvesso 150.

On the mold-release layer of the peelable film, the electro-conductive paste was printed using a screen-printing machine so as to give a size of 2 cm × 5 cm and a film thickness of 15 μm. Thus, the functional pattern was formed.

The sticking layer paste was printed using a screen-printing machine so as to be laid over the functional pattern and to give a size of 2 cm × 5 cm and a film thickness of 10 μm. Thus, the sticking layer was formed.

(Fabrication of Substrate with Functional Pattern)

A substrate with the functional pattern was fabricated by the following procedure.

As the substrate, a glass plate (size: 30 cm × 30 cm) manufactured by the float process was prepared.

The sticking layer of the transfer film for firing immediately after the fabrication was faced to a surface of the glass plate, and the transfer film for firing was pasted thereto with a pressure of 0.5 kg/cm applied, using a roller, onto the first peelable film. Then, the peelable film was peeled off. Thus fabricated was a glass plate to which a laminate including a functional pattern had been transferred.

Then, the glass plate was fired in a firing furnace. The firing conditions were as follows: the temperature was raised from room temperature up to 650°C at a rate of temperature increase of 20°C/min; this temperature was kept for 30 minutes; and the glass plate was radiatively cooled in the furnace down to 100°C or lower.

After that, the cooled glass plate with the functional pattern was taken out of the firing furnace.

(Determination of Thermal Characteristics)

The thermal characteristics of the organic materials and the inorganic powder in the layers of the laminate including the functional pattern were determined as follows. Specifically, in accordance with JIS K 7120 (Testing methods of plastics by thermogravimetry) and using a thermogravimeter "TG-DTA 2000" (manufactured by MAC Science Co. Ltd.), the temperature was raised from room temperature to 650°C at a rate of temperature increase of 20°C/min in an air (the same as the above firing condition) to perform the determination. The thermal characteristics were as follows: the pyrolysis temperature (Tdb) of the organic material contained in the electro-conductive paste was 335°C; the fusion temperature (Tw) of the glass frit was 490°C; the pyrolysis temperature (Tda) of the organic material (hereinafter, simply referred to as the sticking layer) contained in the sticking layer was 414°C; and the pyrolysis-gas generation rate of the sticking layer was 0.47 wt%/sec.

[Table 1]

| Composition | Part by weight |
|---|---|
| Ag | 75 |
| Bi based glass frit | 75 |
| Ethyl cellulose | 4 |
| Terpineol | 8 |
| Dibutyl carbitol | 8 |

(continued)

| Composition | Part by weight |
|---|---|
| Ag | 75 |
| Bi based glass frit | 75 |
| Ethyl cellulose | 4 |
| Terpineol | 8 |
| Dibutyl carbitol | 8 |
| Composition | Part by weight |
| Ag | 75 |
| Bi-based glass frit | 75 |
| Ethylcellulose | 4 |
| Terpineol | 8 |
| Dibutyl carbitol | 8 |

(Example 2)

A transfer film for firing was fabricated by the same method as in Example 1, except that, as a sticking agent used for the sticking layer, an acrylic-based sticking agent "SK1309" (manufactured by Soken Chemical & Engineering Co., Ltd.) was used and the film thickness of the sticking layer was 5 $\mu$m.

A glass plate with a functional pattern was fabricated by the same method as in Example 1, except that, among the firing conditions, the rate of temperature increase was 500˚C/min, and the duration for which the temperature was kept at 650˚C was 5 minutes.

The thermal characteristics determined under temperature rise conditions which were the same as the firing conditions were as follows: the decomposition temperature (Tdb) of the organic material contained in the electro-conductive paste was 355˚C; the fusion temperature (Tw) of the glass frit was 510˚C; the pyrolysis temperature (Tda) of the sticking layer was 481˚C; and the pyrolysis-gas generation rate of the sticking layer was 4.19 wt%/sec.

(Comparative Example 1)

A transfer film for firing was fabricated by the same method as in Example 1, except that, as the sticking agent used for the sticking layer, an acrylic-based sticking agent "SP-205" (TOYO INK MFG. CO., LTD.) was used.

A glass plate with a functional pattern was fabricated by the same method as in Example 1.

The thermal characteristics determined under temperature rise condition which was the same as the firing conditions were as follows: the pyrolysis temperature (Tdb) of the organic material contained in the electro-conductive paste was 335˚C; the fusion temperature (Tw) of the glass frit was 490˚C; the pyrolysis temperature (Tda) of the sticking layer was 309˚C; and the pyrolysis-gas generation rate of the sticking layer was 0.31 wt%/sec.

(Comparative Example 2)

A transfer film for firing was fabricated by the same method as in Example 1, except that the film thickness of the sticking layer was 5 $\mu$m.

A glass plate with a functional pattern was fabricated by the same method as in Example 1, except that the firing conditions were the same as in Example 2

The thermal characteristics determined under temperature rise condition which was the same as the firing conditions were as follows: the decomposition temperature (Tdb) of the organic material contained in the electro-conductive paste was 355˚C; the fusion temperature (Tw) of the glass frit was 510˚C; the pyrolysis temperature (Tda) of the sticking layer was 485˚C; and the pyrolysis-gas generation rate of the sticking layer was 5.01 wt%/sec.

(Assessment)

Table 2 shows the film thickness of the sticking layer, the rate of temperature increase of firing, the thermal characteristics of the functional pattern and the sticking layer, and assessment of the fired body of the functional pattern, in each of Examples 1 and 2 and Comparative Examples 1 and 2. The assessment is shown by the following symbols: "○" meaning that the fired body of the functional pattern had no defects and hence was favorable; and "×" meaning that the fired body of the functional pattern had a defect and hence was unfavorable.

The fired bodies of the functional patterns in Example 1 and Example 2 had no defects, and received a favorable assessment. In contrast, nonuniformity in firing and unsatisfactory adhesion occurred in a part of the fired body of the functional pattern of Comparative Example 1, and breakage such as cracks and peeling occurred in the fired body of the functional pattern of Comparative Example 2. Thus, both failed to receive favorable assessment.

[Table 2]

| Examples | Film thickness of functional pattern (μm) | Film thickness of sticking layer (μm) | temperature increase rate (˚C/min) | Tdb ˚C) | Tda (˚C) | Tw (˚C) | pyrolysis-gas generation rate of sticking layer (wt%/sec) | Assessment |
|---|---|---|---|---|---|---|---|---|
| Example 1 | 15 | 10 | 20 | 335 | 414 | 490 | 0.047 | ○ |
| Example 2 | 15 | 5 | 500 | 355 | 481 | 510 | 4.19 | ○ |
| Comparative Example 1 | 15 | 10 | 20 | 335 | 309 | 490 | 0.31 | × |
| Comparative Example 2 | 15 | 5 | 500 | 355 | 485 | 510 | 5.01 | × |

(Comparison)

Example 1 and Example 2 are compared with each other.

In each of Example 1 and Example 2, the thermal characteristics of the functional pattern and the sticking layer satisfied the relation of: Tdb < Tda < Tw. In particular, in Example 2, the fired body of the functional pattern as favorable as that in Example 1 was obtained, although the rate of temperature increase of firing was 25 times that in Example 1 and was fast, and hence the pyrolysis-gas generation rate of the sticking layer was approximately 8.9 times that in Example 1, and was fast.

It is conceivable that no defects were formed in the fired body of the functional pattern because of the following reason. Specifically, the organic material contained in the functional pattern at the upper layer was earliest pyrolyzed and removed. Then, before the glass frit (inorganic powder) contained in the functional pattern fused, the sticking layer, which was the lower layer, was pyrolyzed and removed.

Examples 1 and 2 are compared with Comparative Example 1.

Example 1 and Comparative Example 1 were the same in thickness of the sticking layer, thickness of the functional pattern and rate of temperature increase of firing, but differed in pyrolysis temperature (Tda) of the sticking layer and pyrolysis-gas generation rate of the sticking layer, because of the difference in kind of the sticking agent used for the sticking layer. Example 2 and Comparative Example 1 differed in fusion temperature (Tw) of the glass frit contained in the functional pattern, pyrolysis temperature (Tda) of the sticking layer, and pyrolysis-gas generation rate of the sticking layer, because of difference in kind of the sticking agent used for the sticking layer, in thickness of the sticking layer, and in rate of temperature increase of firing.

In Comparative Example 1, the pyrolysis temperature (Tda) of the sticking layer was lowest, and thus the thermal characteristics of the functional pattern and the sticking layer did not satisfy the relation of: Tdb < Tda < Tw. The pyrolysis-gas generation rate of the sticking layer in Comparative Example 1 was approximately 0. 66 times that in Example 1, and was relatively slow. Moreover, the pyrolysis-gas generation rate of the sticking layer in Comparative Example 1 was approximately 0.074 times that in Example 2, and relatively very slow. However, no favorable fired body of the functional pattern was obtained in Comparative Example 1.

It is conceivable that, in Comparative Example 1, nonuniformity in firing and unsatisfactory adhesion occurred in a part of the fired body of the functional pattern because of the following reasons. Specifically, the sticking layer, which was the lower layer, was pyrolyzed faster than the organic material contained in the functional pattern at the upper layer was pyrolyzed and removed. Then, the generated pyrolysis-gas was released, while penetrating and breaking some parts of the functional pattern at the upper layer.

The comparison of these shows that, in order to obtain a favorable functional pattern, the relation of: Tdb < Tda < Tw must be satisfied.

Examples 1 and 2 are compared with Comparative Example 2.

Example 1 and Comparative Example 2 were the same in kind of the sticking agent used for the sticking layer, and thickness of the functional pattern, but differed in fusion temperature (Tw) of the glass frit contained in the functional pattern, pyrolysis temperature (Tda) of the sticking layer, and pyrolysis-gas generation rate of the sticking layer, because of the difference in film thickness of the sticking layer and rate of temperature increase of firing. Example 2 and Comparative Example 2 were the same in thickness of the sticking layer, thickness of the functional pattern, and rate of temperature increase of firing, but differed in pyrolysis temperature (Tda) of the sticking layer, and pyrolysis-gas generation rate of the sticking layer, because of the difference in kind of the sticking agent used for the sticking layer. However, the differences were small.

In Comparative Example 2, the thermal characteristics of the functional pattern and the sticking layer satisfied the relation of: Tdb < Tda < Tw, and the film thickness of the sticking layer was half that in Example 1. However, no favorable fired body of the functional pattern was obtained. At this time, the pyrolysis-gas generation rate of the sticking layer in Comparative Example 2 was approximately 10.7 times that in Example 1, and was relatively fast, but was relatively not so high when compared with the fact that the pyrolysis-gas generation rate of the sticking layer in Example 2 was approximately 8.9 times that in Example 1.

In Comparative Example 2, the pyrolysis of the organic material contained in the functional pattern at the upper layer and the pyrolysis of the sticking layer, which was the lower layer, proceeded substantially simultaneously. Hence, the pyrolysis-gas generation rate of the sticking layer exceeded the limit. As a result, the generated pyrolysis-gas from the sticking layer was released, while penetrating and breaking parts of the functional pattern at the upper layer. It is conceivable that, for the above-described reason, breakage such as cracks and peeling occurred in the fired body of the functional pattern of Comparative Example 2. It is conceivable that, because the pyrolysis-gas generation rate of the sticking layer did not exceed the limit, no breakage was observed in the functional pattern of Example 2 where the firing was performed at the same rate of temperature increase.

The comparison of these shows that, in order to obtain a favorable fired body with a functional pattern when the firing is performed at a high rate of temperature increase, the pyrolysis-gas generation rate of the sticking layer is also an important factor, in addition to the satisfaction of the relation of: Tdb < Tda < Tw.

(Example 3)

(Fabrication of Transfer Film for Firing)

A transfer film for firing whose configuration was similar to that of the transfer film for firing in Example 1 but which further included the intermediate layer and the second peelable film was fabricated by the following procedure.

As the first peelable film, the same PET film as in Example 1 was prepared.

As the second peelable film, a PET film including a silicone-based mold-release layer "A31" (manufactured by Teijin DuPont Films Japan Limited, film size: 20 cm × 30 cm, thickness: 25 μm) was prepared.

As the coating liquid for the functional pattern, the same electro-conductive paste as in Example 1 was prepared.

As the coating liquid for the intermediate layer, a polyvinyl-acetal-based resin "KW1" (manufactured by Sekisui Chemical Co., Ltd.) was prepared, and an intermediate layer paste was prepared therefrom.

As the coating liquid for the sticking layer, the same acrylic-based sticking agent "SK1309" as in Example 2 was prepared, and a sticking layer paste was prepared therefrom.

On the mold-release layer of the first peelable film, the electro-conductive paste was printed using a screen-printing machine so as to give a size of 2 cm × 5 cm, and a film thickness of 15 μm. Thus, the functional pattern was fabricated.

The intermediate-layer paste was coated using a Meyer bar so as to cover the functional pattern and to give a size of 5 cm × 10 cm and a film thickness of 2 μm. Thus, the intermediate layer was fabricated.

Next, drying was performed in an oven at 120˚C for 10 minutes.

The sticking-layer paste was coated using a Meyer bar so as to be laid over the intermediate pattern and to give a size of 5 cm × 10 cm and a film thickness of 1 μm. Thus, the sticking layer was fabricated.

The mold-release layer side of the second peelable film was pasted to cover the sticking layer.

In the above-described manner, two transfer films for firing were fabricated. These transfer films for firing were stored under a temperature condition of 30˚C.

(Fabrication of Substrate with Functional Pattern)

By using the two transfer films for firing stored under the temperature condition, substrates with functional patterns were fabricated by the following procedure, after one hour and after one week, respectively.
As the substrate, a glass plate (size: 30 cm × 30 cm) manufactured by the float process was prepared.
The second peelable film was peeled off from the transfer film for firing.
The sticking layer of the transfer film for firing was faced to a surface of the glass plate, and the transfer film for firing was pasted thereto with a pressure of 0.5 kg/cm applied, using a roller, onto the first peelable film. Then, the first peelable film was peeled off. Thus fabricated was a glass plate to which a laminate including a functional pattern had been transferred.
Then, the glass plate was fired in a firing furnace. Thus fabricated was a glass plate with the functional pattern. The firing conditions were the same as in Example 1.

(Determination of Thermal Characteristics)

The thermal characteristics of the organic materials and the inorganic powder in layers of the laminate including the functional pattern were determined under temperature rise conditions which were the same as the firing conditions. The thermal characteristics were as follows: the pyrolysis temperature (Tdb) of the organic material contained in the electro-conductive paste was 335˚C; the fusion temperature (Tw) of the glass frit was 490˚C; the pyrolysis temperature (Tda) of the sticking layer was 401˚C; the pyrolysis-gas generation rate thereof was 0.51 wt%/sec; and the pyrolysis temperature (Tdm) of the organic material contained in the intermediate layer (hereinafter, simply referred to as the intermediate layer) was 370˚C.

(Comparative Example 3)

Two transfer films for firing whose configurations are similar to those of the transfer films for firing in Example 3 but which did not include the intermediate layers were fabricated by the same method as in Example 3.
Two glass plates with functional patterns were fabricated by the same method as in Example 3, by using two transfer films for firing which were stored for different periods of time.

(Assessment)

In each of Example 3 and Comparative Example 3, in order to check the effect of the intermediate layer, the film thickness of the sticking layer was intentionally changed to 1 μm, with which sticking performance became unstable. Since the sticking layer was covered with the second peelable film immediately before the transfer, attachment of dust or the like to the sticking layer was successfully prevented.
Table 3 shows assessment of the state of the transfer of the laminate including the functional pattern of the transfer film for firing to the glass plate (hereinafter, referred to as transferability), and assessment of the state of the fired body of the functional pattern (hereinafter, referred to as firing ability), in Example 3 and Comparative Example 3. The assessment of the transferability is shown by the following symbols: "○" meaning that the sticking was favorable with no floating of the laminate from the glass plate; "×" meaning that the sticking was unfavorable with partial floating of the laminate from the glass plate; and "-" meaning that the transfer of the laminate to the glass plate failed. The assessment of the firing ability is shown by the following symbols: "○" meaning that the fired body of the functional pattern had no defect, and was favorable; "×" meaning that the fired body of the functional pattern had a defect, and unfavorable; and "-" meaning that the firing failed.
In Example 3, both of the transferability and the firing ability in the case where the storage period was one hour were favorable, and both of the transferability and the firing ability in the case where the storage period was one week were also favorable. In contrast, in Comparative Example 3, neither the transferability nor the firing ability in the case where the storage period was one hour was favorable, and in the case where the storage period was 1 week, the laminate was unable to be transferred to the glass plate and, no firing was possible.

[Table 3]

| | Transferability after one hour | Firing ability after one hour | Transferability after one week | Firing ability after one week |
|---|---|---|---|---|
| Example 3 | ○ | ○ | ○ | ○ |
| Comparative Example 3 | × | × | - | - |

(Comparison)

Example 3 is compared with Comparative Example 3.

The transfer films for firing in Example 3 and the transfer films for firing in Comparative Example 3 differed only in the presence or absence of the intermediate layer. It is conceivable that, when no intermediate layer was provided, the sticking agent contained in the sticking layer was transferred to the functional pattern, which resulted in weak sticking performance. It is conceivable that, when the intermediate layer was provided, this transfer of the sticking agent was prevented and the sticking performance was maintained.
From the comparison, it was confirmed that it is possible to make the film thickness of the sticking layer thin by forming, between the sticking layer and the functional pattern, an intermediate layer capable of preventing the sticking agent from being transferred.

(Example 4)

A transfer film for firing was fabricated by the same method as in Example 3, except that a hydroxycellulose-based resin "SP200" (manufactured by DAICEL CHEMICAL INDUSTRIES, LTD.) was used as the intermediate layer which had a film thickness of 2 $\mu$m.
A glass plate with a functional pattern was fabricated by using the transfer film for firing by the same method as in Example 3, except that, among the firing conditions, the rate of temperature increase was 500˚C/min, and the duration for which the temperature was kept at 650˚C was 5 minutes.
The thermal characteristics determined under temperature rise conditions which were the same as the firing conditions were as follows: the pyrolysis temperature (Tdb) of the organic material contained in the electro-conductive paste was 355˚C; the fusion temperature (Tw) of the glass frit was 510 ˚C; the pyrolysis temperature (Tda) of the sticking layer was 481˚C, the pyrolysis-gas generation rate thereof was 4.19 wt%/sec; and the pyrolysis temperature (Tdm) of the intermediate layer was 370˚C.

(Comparative Example 4)

A transfer film for firing was fabricated by the same method as in Example 3, except that a carboxymethyl cellulose-based resin "CMC-1240" (manufactured by DAICEL CHEMICAL INDUSTRIES, LTD.) was used as the intermediate layer that had a film thickness of 2 $\mu$m.
Transfer formation was performed on a glass plate.
A glass plate with a functional pattern was fabricated by using the transfer film for firing by the same method as in Example 3.
The thermal characteristics determined under temperature rise conditions which were the same as the firing conditions were as follows: the decomposition temperature (Tdb) of the organic material in the electro-conductive paste was 419˚C; the fusion temperature (Tw) of the glass frit was 510˚C; the pyrolysis temperature (Tda) of the organic material in the sticking layer was 414˚C; the pyrolysis-gas generation rate thereof was 0.47 wt%/sec; the pyrolysis temperature (Tdm) of the organic material in the intermediate layer was 290˚C.

(Comparative Example 5)

A transfer film for firing was fabricated by the same method as in Example 3, except that an acrylic-based resin "BR50," (manufactured by Mitsubishi Rayon Co., Ltd.) was used as the intermediate layer which was formed in a film thickness of 2 $\mu$m.
A glass plate with a functional pattern was fabricated using the transfer film for firing by the same method as in Example 3, except that the firing conditions as in Example 4 were employed.
The thermal characteristics determined under temperature rise conditions which were the same as the firing conditions were as follows: the pyrolysis temperature (Tdb) of the organic material in the electro-conductive paste was 355°C; the fusion temperature (Tw) of the glass frit was 510°C; the pyrolysis temperature (Tda) of the sticking layer was 481°C, the pyrolysis-gas generation rate thereof was 4.19 wt%/sec; and the pyrolysis temperature (Tdm) of the intermediate layer was 492°C.

(Assessment) .

Table 4 shows the rates of temperature increase of firing, thermal characteristics of layers, and assessment of the fired bodies of the functional patterns in Examples 3 and 4 and Comparative Examples 4 and 5. The assessment is shown by the following symbols: "○" meaning that the fired body of the functional pattern had no defect, and was favorable; and "×" meaning that the fired body of the functional pattern had a defect, and unfavorable.

In each of Example 3 and Example 4, the fired body of the functional pattern had no defect, and received a favorable assessment. In contrast, breakage occurred in the fired body of the functional pattern in Comparative Example 4, and unsatisfactory adhesion occurred in the fired body of the functional pattern in Comparative Example 5. Thus, the two did not receive a favorable assessment.

[Table 4]

| Examples | temperature increase rate (°C/min) | Tdb (°C) | Tdm (°C) | Tda (°C) | Tw (°C) | pyrolysis-gas generation rate of sticking layer (wt%/sec) | Assessment |
|---|---|---|---|---|---|---|---|
| Example 3 | 20 | 335 | 370 | 401 | 490 | 0.51 | ○ |
| Example 4 | 500 | 355 | 370 | 481 | 510 | 4.19 | ○ |
| Comparative Example 4 | 20 | 335 | 290 | 401 | 490 | 0.51 | × |
| Comparative Example 5 | 500 | 355 | 492 | 481 | 510 | 4.19 | × |

(Comparison)

Example 3 and Example 4 are compared with each other.

In each of Example 3 and Example 4, thermal characteristics of the layers satisfied the relation of: Tdb < Tdm < Tda < Tw. In particular, in Example 2, the rate of temperature increase of firing was 25 times that in Example 3, and relatively fast, and, in turn, the pyrolysis-gas generation rate of the sticking layer was approximately 8.2 times that in Example 3, and relatively fast. However, a fired body of a functional pattern as favorable as that in Example 3 was obtained. This result is the same as the relation between Example 1 and Example 2 in which no intermediate layers were provided.

Example 3 is compared with Comparative Example 4.

Example 3 and Comparative Example 4 differed in resin used as the intermediate film. As a result, in Comparative Example 4, the pyrolysis temperature (Tdm) of the intermediate film was lower than the pyrolysis temperature (Tdb) of the organic material contained in the functional pattern. Accordingly, it is conceivable that, in Comparative Example 4, breakage occurred in the fired body of the functional pattern because of the following reasons. Specifically, the intermediate layer, which was the lower layer, was pyrolyzed faster than the organic material contained in the functional pattern at the upper layer was pyrolyzed and removed. Then, the generated pyrolysis-gas was released, while penetrating and breaking some parts of the functional pattern at the upper layer.

Example 4 is compared with Comparative Example 5.

Example 4 and Comparative Example 5 differed in resin used as the intermediate film. As a result, in Comparative Example 5, the pyrolysis temperature (Tdm) of the intermediate film was higher than the pyrolysis temperature (Tda) of the sticking layer. Accordingly, it is conceivable that, in Comparative Example 5, unsatisfactory adhesion occurred in the fired body of the functional pattern because of the following reasons. Specifically, the sticking layer, which was the lower layer, was pyrolyzed faster than the intermediate film, which was an upper layer, was pyrolyzed and removed. Then, the generated pyrolysis-gas pushed up some parts of the intermediate layer, which was an upper layer, and the intermediate layer pushed up the functional pattern at the upper layer thereof.

From the above comparison, it was confirmed that, even in a case where the number of layers in the laminate including the functional pattern was increased, a fired body of a functional pattern without defects was successfully obtained, when the organic materials contained in the layers are sequentially pyrolyzed from the upper layer, and the layers lower than the functional pattern were pyrolyzed and removed before the inorganic powder contained in the functional pattern fused, in other words, when the relation of: Tdb < Tdm < Tda < Tw was satisfied.

(Example 5)

(Fabrication of Transfer Film for Firing)

A transfer film for firing was fabricated whose configuration was similar to that of the transfer film for firing in Example 1 but further included the intermediate layer, the protective layer and the second peelable film by the following procedure.

As the first peelable film, a PET film including a weakly sticking layer "SRL-0754" (manufactured by Lintec Corporation, film size: 20 cm × 30 cm, thickness: 75 μm) was prepared.

As the second peelable film, a PET film including a silicone-based mold-release layer "A31" (manufactured by Teijin DuPont Films Japan Limited, film size: 20 cm × 30 cm, thickness: 38 μm) was prepared.

As the coating liquid for the protective layer, a polyethylene-oxide-based resin "PEO-8Z" (manufactured by Sumitomo Seika Chemicals Company Limited) was prepared, and a protective layer paste was prepared therefrom.

As the coating liquid for the functional pattern, the same electro-conductive paste as in Example 1 was prepared.

As the coating liquid for the intermediate layer, the same polyvinyl-acetal-based resin "KW1" as in Example 3 was prepared, and an intermediate layer paste was prepared therefrom.

As the coating liquid for the sticking layer, the same acrylic-based sticking agent "SK1309" as in Example 3 was prepared, and a sticking layer paste was prepared therefrom.

On the mold-release layer of the second peelable film, the sticking layer paste was coated using a Meyer bar so as to give a size of 5 cm × 10 cm, and a film thickness of 5 μm. Thus, the functional pattern was formed.

The intermediate-layer paste was coated using an applicator so as to cover the sticking layer and to give a size of 6 cm × 12 cm and a film thickness of 2 μm. Thus, the intermediate layer was formed.

On the intermediate layer, the electro-conductive paste was printed by screen-printing so as to give a size of 0.3 mm × 5 cm, and a film thickness of 15 μm. Thus, the functional pattern was formed.

The protective layer paste was coated using an applicator so as to cover the functional pattern and to give a size of 6 cm× 12 cm, and a film thickness of 3 μm. Thus, the protective layer was formed.

The weakly sticking layer side of the first peelable film was pasted so as to cover the protective layer.

(Fabrication of Substrate with Functional Pattern)

A substrate with a functional pattern was fabricated by the following procedure.

As the substrate, a glass plate (size: 30 cm × 30 cm) manufactured by the float process was prepared.

The second peelable film was peeled off from the transfer film for firing.

The sticking layer of the transfer film for firing was faced to a surface of the glass plate. Then, while bent at a curvature of Φ 5 mm, the transfer film for firing was pasted to the glass plate with a pressure of 0.5 kg/cm applied, using a roller, onto the first peelable film. Thereafter, the first peelable film was peeled off. Thus fabricated was a glass plate to which a laminate including the functional pattern had been transferred.

Then, the glass plate was fired in a firing furnace, under the same firing conditions as in Example 1. Thus, a glass plate with the functional pattern was fabricated.

(Determination of Thermal Characteristics)

The thermal characteristics of the organic materials and the inorganic powder in the layers of the laminate including the functional pattern were determined under temperature rise conditions which were the same as the firing conditions. The thermal characteristics were as follows: the pyrolysis temperature (Tdb) of the organic material contained in the electro-conductive paste was 335°C; the fusion temperature (Tw) of the glass frit was 490°C; the pyrolysis temperature (Tda) of the sticking layer was 401°C; the pyrolysis-gas generation rate thereof was 0.51 wt%/sec; the pyrolysis temperature (Tdm) of the intermediate layer was 370°C; and the pyrolysis temperature (Tdp) of the organic material (hereinafter, simply referred to as the protective layer) contained in the protective layer was 305°C.

(Comparative Example 6)

A transfer film for firing was fabricated by the same method as in Example 5, except that, for the protective layer paste, the polyacetal-based resin "KW1" which is the same as that for the intermediate layer paste was used, and coated using an applicator to give a film thickness of 3 μm.

A glass plate with a functional pattern was fabricated using the transfer film for firing by the same method as in Example 5.

The thermal characteristics determined under temperature rise condition which were the same as the firing conditions were as follows: the pyrolysis temperature (Tdb) of the organic material in the electro-conductive paste was 335°C, the fusion temperature (Tw) of the glass frit was 490°C; the pyrolysis temperature (Tda) of the sticking layer was 401°C; the pyrolysis-gas generation rate thereof was 0.51 wt%/sec; the pyrolysis temperature (Tdm) of the intermediate layer was 370°C; and the pyrolysis temperature (Tdp) of the protective layer was 370°C.

(Assessment)

Table 5 shows the determined values of the thermal characteristics of the layers, the assessment of transferability and combustibility in Example 5 and Comparative Example 6. The assessment of the transferability is shown by the following symbols: "○" meaning that the sticking was favorable with no floating of the laminate from the glass plate; "×" meaning that the sticking was unfavorable with partial floating of the laminate from the glass plate; and "-" meaning that the transfer of the laminate to the glass plate failed. The assessment of the firing ability is shown by the following symbols: "○" meaning that the fired body of the functional pattern had no defect, and was favorable; "×" meaning that the fired body of the functional pattern had a defect, and unfavorable; and "-" meaning that the firing failed.

[Table 5]

| Examples | Tdp (°C) | Tdb (°C) | Tdm (°C) | Tda (°C) | Tw (°C) | Transferability | Combusti-a bility |
|---|---|---|---|---|---|---|---|
| Example 5 | 305 | 335 | 370 | 401 | 490 | ○ | ○ |
| Comparative Example 6 | 370 | 355 | 370 | 401 | 490 | ○ | × |

In each of Example 5 and Comparative Example 6, when the laminate including the functional pattern was transferred to the substrate, the transfer film for firing is pasted on the substrate, while bent at a curvature of Φ 5 mm. However, no cracks were formed, and a favorable transferability was achieved. It is conceivable that this was made possible because the protective layer protected the functional pattern which was brittle before the firing.

In Example 5, no cracks were formed in the fired body of the functional pattern, and a favorable combustibility was achieved. However, in Comparative Example 6, the nonuniformity in firing and unsatisfactory adhesion occurred in a part of the fired body of the functional pattern, and no favorable combustibility was achieved.

In Comparative Example 6, the pyrolysis temperature (Tdp) of the protective layer, which was the uppermost layer, was higher than the pyrolysis temperature (Tdb) of the organic material contained in the functional pattern lower than the uppermost layer. Accordingly, it is conceivable that, the release of the pyrolysis-gas from the organic material contained in the functional pattern was prevented by the protective layer, and no favorable combustibility was achieved.

From the above comparison, it was confirmed that, even in a case where the number of layers in the laminate including the functional pattern was increased, the fired body of the functional pattern without defects was successfully obtained, when the organic materials contained in the layers were sequentially pyrolyzed from the upper layer, and the layers lower than the functional pattern were pyrolyzed and removed before the inorganic powder contained in the functional pattern fused, in other words, when the relation of: Tdp < Tdb < Tdm < Tda < Tw was satisfied.

Next, regarding the second aspect, specific examples of the present invention will be described. The present invention is not limited to these examples.

(Example 6)

(Fabrication of Transfer Film for Firing)

A transfer film for firing was fabricated by the following procedure.

As the peelable film serving as a supporting body, a PET film including a silicone-based peelable layer "A70" (manufactured by Teijin DuPont Films Japan Limited, film size: 20 cm × 30 cm, thickness: 25 μm) was prepared.

As the coating liquid for the adhesive layer, an acrylic-based resin "BR1122" (manufactured by Mitsubishi Rayon Co. , Ltd.) was prepared, and an adhesive layer paste was prepared therefrom.

As the coating liquid for the functional pattern, an electro-conductive paste containing a glass frit, a Ag powder, and an organic material "H4170" (manufactured by SHOEI CHEMICAL INC.) was prepared.

The adhesive layer paste was coated using a Mayor bar all over the surface on the peelable layer side of the peelable film to give a thickness of 10 μm. Thus, the adhesive layer was formed. Then, the solvent contained in the adhesive layer was vaporized sufficiently.

In the vicinity of the center of the adhesive layer, the electro-conductive paste was printed by screen printing to give a size of 2 cm × 5 cm, and a thickness of 15 μm. Thus, a functional pattern was formed.

From the peelable film on which the adhesive layer and the functional pattern were formed, the portion including the functional pattern was cut in a size of 5 cm × 10 cm. Thus, a transfer film for firing of Example 6 was fabricated.

(Fabrication of Substrate with Functional Pattern)

A substrate with a functional pattern was fabricated by the following procedure.

As the substrate, a glass plate (size: 10 cm × 10 cm) manufactured by the float process was prepared.

The transfer film for firing was pasted to a surface of the glass plate, while the functional pattern of the transfer film for firing was faced to the glass plate. The glass plate was placed on a substantially flat table, with the transfer film for firing located on upside. The glass plate was heated and pressurized using a rubber roller heated at 150˚C with a pressure of 0.5 kg/cm applied onto the peelable film. Then, after the plate was stood at room temperature for one minute, the peelable film was peeled off. Thus fabricated was a glass plate to which the laminate including the functional pattern was transferred. It is conceivable that, since the temperature employed in the heating was enough to soften the material in the adhesive layer, air, which might otherwise have presented between the adhesive layer and the functional pattern, was removed, when the roller moved.

Then, the glass plate to which the laminate including the functional pattern was transferred was fired in a firing furnace "P90" (manufactured by DENKEN CO. LTD), while placed substantially flat. The firing conditions were as follows: the temperature was raised from room temperature up to 600˚C at a rate of temperature increase of 20˚C/min in an air atmosphere; this temperature was kept for 30 minutes; the heating was stopped; and the glass plate was radiatively cooled in the furnace down to 100˚C or lower.

After that, the cooled glass plate with a functional pattern was taken out of the firing furnace.

(Determination of Thermal Characteristics)

The pyrolysis completion temperatures of the organic materials contained in the layers of the laminate including the functional pattern were determined in accordance with JIS K 7120 (Testing methods of plastics by thermogravimetry) using a thermogravimeter "TG-DTA 2000" (manufactured by MAC Science Co. Ltd.). Note that, in the present invention, the term "pyrolysis completion temperature" refers to a temperature having the same meaning as that of the term "completion temperature" in the above-described determination method.

The results determined under temperature rise condition which were the same as the firing conditions were as follows: the pyrolysis completion temperature of the organic material (hereinafter, simply referred to as the adhesive layer) contained in the adhesive layer was 350˚C; and the pyrolysis completion temperature of the organic material contained in the electro-conductive paste was 425˚C.

(Example 7)

A transfer film for firing of Example 7 was fabricated by the same method as in Example 6, except that, for the adhesive layer paste, an acetylcellulose resin "L-20" (manufactured by DAICEL CHEMICAL INDUSTRIES, LTD.) was used.

Then, a glass plate to which the laminate including the functional pattern was transferred was fabricated by the same method as in Example 6, and then a glass plate with the functional pattern was fabricated under the same firing conditions as in Example 6.

The result determined under temperature rise condition which was the same as the firing conditions was that the pyrolysis completion temperature of the adhesive layer was 390˚C.

(Comparative Example 7)

A transfer film for firing of Comparative Example 7 was fabricated by the same method as in Example 6, except that for the adhesive layer paste, a polybutyral resin "BL-S" (manufactured by Sekisui Chemical Co., Ltd.) was used.

Then, a glass plate to which a laminate including a functional pattern was transferred was fabricated by the same method as in Example 6, and then a glass plate with the functional pattern was fabricated under the same firing conditions as in Example 6.

The result determined under temperature rise condition which was the same as the firing conditions was that the pyrolysis completion temperature of the adhesive layer was 435˚C.

(Comparative Example 8)

A transfer film for firing of Comparative Example 8 was fabricated by the same method as in Example 6, except that, for the adhesive layer paste, a polyacetal resin "KX-1" (manufactured by Sekisui Chemical Co., Ltd.) was used.

Then, a glass plate to which a laminate including a functional pattern was transferred was fabricated by the same method as in Example 6, and a glass plate with the functional pattern was fabricated under the same firing conditions as in Example 6.

The result determined under temperature rise conditions which were the same as the firing conditions was that the pyrolysis completion temperature of the adhesive layer was 560˚C.

(Assessment)

Table 6 shows the pyrolysis completion temperatures of the organic materials contained in the adhesive layer and the functional pattern in each transfer film for firing, and assessment of the fired body of the inorganic powder including the glass frit and a Ag powder contained in each functional pattern (hereinafter, simply referred to as the fired body of the functional pattern), in Examples 6 and 7 and Comparative Examples 7 and 8. The assessment is shown by the following symbols: ○" meaning that the fired body of the functional pattern had no defects and hence was favorable; and "×" meaning that the fired body of the functional pattern had a defect and hence was unfavorable.

The laminates including the functional patterns of the transfer films for firing in Examples 6 and 7 and in Comparative Examples 7 and 8 had the same configuration, except that the materials for the adhesive layers differed.

The appearance of the fired body of the functional pattern in each of Examples 6 and 7 was such that none of unevenness in color, floating, cracks and peeling-off was observed, and received a favorable assessment. In contrast, the appearance of the fired body of the functional pattern in each of Comparative Examples 7 and 8 was such that breakage such as unevenness in color, floating, cracks and peeling-off occurred, and was unfavorable.

[Table 6]

| | Pyrolysis completion temperature of organic materials (˚C) | | Assessment |
| --- | --- | --- | --- |
| | Adhesive layer | Functional pattern | |
| Example 6 | 350 | 425 | ○ |
| Example 7 | 390 | 425 | ○ |
| Comparative Example 7 | 435 | 425 | × |
| Comparative Example 8 | 565 | 425 | × |

(Comparison)

Examples 6 and 7 are compared with Comparative Examples 7 and 8.

In each of Example 6 and Example 7, the pyrolysis completion temperature of the adhesive layer located as an upper layer was lower than the pyrolysis completion temperature of the organic material contained in the functional pattern located lower than the adhesive layer. In contrast, in each of Comparative Example 7 and Comparative Example 8, the pyrolysis completion temperature of the adhesive layer located as the upper layer was higher than the pyrolysis completion temperature of the organic material contained in the functional pattern located lower than the adhesive layer.

From the relation of these pyrolysis completion temperatures, it is conceivable that, in each of Example 6 and Example 7, the release of the pyrolysis-gases from the organic materials in the layers occurred sequentially from the upper layer, and hence no defects was caused in the fired body of the functional pattern. In contrast, it is conceivable that, in Comparative Example 7 and Comparative Example 8, the pyrolysis-gas from the organic material contained in the functional pattern was obstructed by the adhesive layer, which was the upper layer, and the pressure due to the pyrolysis-gas caused the defects in the fired body of the functional pattern.

The comparison of these shows that, in order to obtain a favorable fired body of a functional pattern, the pyrolysis completion temperature of the adhesive layer located as the upper layer needs to be lower than the pyrolysis completion temperature of the organic material contained in the functional pattern located lower than the adhesive layer.

(Example 8)

(Fabrication of Transfer Film for Firing)

A transfer film for firing including two adhesive layers (a first adhesive layer and a second adhesive layer) and two peelable films (a first peelable film and a second peelable film) was fabricated by the following procedure.

As the first peelable film, the same PET film as in Example 6 was prepared.

As the second peelable film, a PET film including a silicone-based peelable layer "A31" (manufactured by Teijin DuPont Films Japan Limited, film size: 20 cm × 30 cm, thickness: 25 μm) was prepared.

For the adhesive layer paste, an ethylcellulose rein "N-50" (manufactured by Hercules, pyrolysis completion temperature: 384.0˚C) was prepared.

As the coating liquid for the functional pattern, the same electro-conductive paste as in Example 6 was prepared.

As the coating liquid for the first adhesive layer, the same adhesive layer paste as in Example 6 was prepared as a first adhesive layer paste.

For the coating liquid for the second adhesive layer, an acrylic-based sticking agent "SK1451" (manufactured by Soken Chemical & Engineering Co., Ltd., pyrolysis completion temperature: 450˚C) was prepared, and a second adhesive layer paste was formed therefrom. This second adhesive paste was sticker than the first adhesive paste.

On the peelable layer of the first peelable film, the first adhesive layer and a functional pattern were formed by the same method as in Example 6. Then, the solvent contained in the functional pattern was sufficiently vaporized.

Then, on the part of the first adhesive layer where no functional pattern was formed, the second adhesive layer paste was printed by screen printing in substantially the same thickness as the functional pattern to form the second adhesive layer. Further, onto the functional pattern and the second adhesive layer, the second peelable film was pasted, while the peelable layer thereof was faced to the functional pattern and the second adhesive layer.

From the pasted film, the part including the functional pattern was cut out in a size of 5 cm × 10 cm. Thus, a transfer film for firing of Example 8 was fabricated.

(Fabrication of Substrate with Functional Pattern)

A substrate with a functional pattern was fabricated by the following procedure.

As the substrate, the same glass plate as in Example 6 was prepared.

The second peelable film was peeled off from the transfer film for firing. Then, the transfer film for firing was pasted to a surface of the glass plate, while the functional pattern of the transfer film for firing faced to the glass plate. The glass plate was placed on a substantially flat table, with the transfer film for firing located on the upper side. The glass plate was pressurized with a pressure of 5 kg/cm applied, using a rubber roller, onto the first peelable film. Then, the first peelable film was peeled off and a glass plate to which the laminate including the functional pattern was transferred was fabricated. Since a highly sticky material was used for the second adhesive paste, the laminate including the functional pattern was successfully transferred to the surface of the glass plate, without heating the rubber roller.

Then, under the same firing conditions as in Example 6, the glass plate to which the laminate including the functional pattern was transferred was fired, and the glass plate with the functional pattern was fabricated.

(Determination of Thermal Characteristics)

The results determined under temperature rise conditions which were the same as the firing conditions were as follows: the pyrolysis completion temperature of the first adhesive layer was 384˚C; and the pyrolysis temperature of the organic material (hereinafter, simply referred to as the second adhesive layer) contained in the second adhesive layer was 450˚C.

(Assessment)

Table 7 shows the pyrolysis completion temperatures of the organic materials contained in the layers of the laminate including the functional pattern of the transfer film for firing of Example 8 and assessment of the fired body of the functional pattern.

The appearance of the fired body of the functional pattern was such that none of unevenness in color, floating, cracks and peeling-off was observed, and received a favorable assessment.

The laminate had a structure in which the second adhesive layer was formed on the part where no functional pattern was formed in the laminate in Example 6, and the first adhesive layer was formed both on the functional pattern and on the second adhesive layer.

[Table 7]

| | Pyrolysis completion temperature of organic materials (˚C) | | | Assessment |
|---|---|---|---|---|
| | First adhesive layer | Second adhesive layer | Functional pattern | |
| Example 8 | 384 | 450 | 425 | ○ |

(Comparison)

Example 6 and Example 8 are compared with each other.

First, comparison is made between states during the transfer of the laminate including the functional pattern to the surface of the glass plate.

In the fabrication method of the transfer film for firing in Example 6, since the functional pattern was formed on the adhesive layer, difference in level is formed at the boundary between the functional pattern and the adhesive layer by an amount of thickness of the functional pattern. For this reason, in a case where the thickness of the functional pattern becomes large, when the laminate including a functional pattern is transferred to a surface of a glass plate, and only application of heat and pressure with the rubber roller is performed, air may remain at the boundary between the functional pattern and the adhesive layer. In contrast, the fabrication method of the transfer film for firing in Example 8, since the second adhesive layer was formed on portions where no functional pattern was formed, it is possible to make difference in level less likely to be formed at the boundary between the functional pattern and the second adhesive layer. Hence, it is less likely that air remains in the boundary between the functional pattern and the adhesive layer when the laminate including a functional pattern is transferred to the surface of the glass plate.

Next, comparison is made between pyrolysis completion temperatures of the organic materials contained in the layers of the laminates including functional patterns.

In the laminate transferred to the surface of the glass plate in Example 6, the adhesive layer covered portions excluding the portion in contact with the surface of the glass plate of the functional pattern. Hence, in not only the upper side of the functional pattern, but also all the boundary portions between the functional pattern and the adhesive layer, the pyrolysis completion temperature of the adhesive layer was lower than the pyrolysis completion temperature of the organic material contained in the functional pattern. In contrast, in the laminate transferred to the surface of the glass plate of Example 8, the same relation of the pyrolysis completion temperatures as in Example 6 held in the portion formed of the functional pattern and the first adhesive layer formed thereon. In addition, in the portion formed of the second adhesive layer and the first adhesive layer formed thereon, the pyrolysis completion temperature of the first adhesive layer, which was the upper layer, was lower than the pyrolysis completion temperature of the second adhesive layer lower than the first adhesive layer. However, in the portion formed of the functional pattern and the second adhesive layer formed on the sides of the functional pattern, the pyrolysis completion temperature of the second adhesive layer was higher than the pyrolysis completion temperature of the organic material contained in the functional pattern. Despite such a difference, the fired body of the functional pattern of Example 8 was as favorable as the fired body of the functional pattern of Example 6.

The comparison shows that the requirement that the pyrolysis completion temperature of the adhesive layer covering the functional pattern be lower than the pyrolysis completion temperature of the organic material contained in the functional pattern is not necessarily satisfied in all portions of the adhesive layer, but the requirement may be satisfied at least in portions on the upper side of the functional pattern.

Note that, in Example 8, even when the functional pattern and the second adhesive layer overlap with each other in the production of the transfer film for firing, the pyrolysis completion temperature of the organic material contained in the functional pattern is lower than the pyrolysis completion temperature of the second adhesive layer. Hence, it can be easily understood that the relation that the pyrolysis completion temperature of an upper layer is lower than the pyrolysis completion temperature of a lower layer holds, and that a favorable fired body with a functional pattern can be obtained.

(Example 9)

(Fabrication of Transfer Film for Firing)

A transfer film for firing including two adhesive layers (a first adhesive layer and a second adhesive layer) and two peelable films (a first peelable film and a second peelable film) was fabricated by the following procedure.
As the first peelable film, the same PET film as in Example 6 was prepared.
As the second peelable film, the same PET film as in Example 8 was prepared.
As a mask film used in coating the electro-conductive paste, a PET film "T60" (manufactured by TORAY INDUSTRIES, INC., film size: 20 cm $\times$ 30 cm, thickness: 25 $\mu$m) was prepared, and a pattern hole of 2 cm $\times$ 5 cm was formed in the vicinity of the center of the film.
As the coating liquid for the functional pattern, the same electro-conductive paste as in Example 6 was prepared.
As the coating liquid for the two adhesive layers, the same adhesive layer paste as in Example 6 was prepared, and used as a first adhesive layer paste and a second adhesive layer paste.
The first adhesive layer paste was coated using a Meyer bar all over the surface of the first peelable film on the peelable layer side so as to give a thickness of 20 $\mu$m. Thus, the first adhesive layer was formed. Then, the solvent contained in the first adhesive layer was sufficiently vaporized.
The peelable layer side of the second peelable film and the mask film to which the pattern hole has been provided were overlapped with each other. The electro-conductive paste was coated on and through the mask film by using an applicator which is capable of providing a WET thickness of 50 $\mu$m. Then, the mask film was removed. Thus formed on the second peelable film was a functional pattern having a size of 2 cm $\times$ 5 cm, and a thickness of 15 $\mu$m.
After the solvent contained in the functional pattern was sufficiently vaporized, the second adhesive layer paste was coated all over the surface of the second peelable film on which the functional pattern was formed using a Meyer bar to give a thickness of 20 $\mu$m. Thus, the second adhesive layer was formed. Then, the solvent contained in the second adhesive layer was sufficiently vaporized.
Next, the first adhesive layer of the first peelable film and the second adhesive layer of the second peelable film were overlapped with each other, while avoiding inclusion of air therebetween, to form a composite. The composite was placed on a hot plate at a temperature of 100˚C, while the second peelable film was located on the lower side. The entire surface of the composite was pressurized with a load of 0.1 kg/cm$^2$ applied onto the first peelable film, and the state was held for 10 minutes. Since the temperature employed for the heating was enough to soften the material of the two adhesive layers, the first adhesive layer and the second adhesive layer were united. Since the material of the two adhesive layers was the same, the united adhesive layers can be regarded as one adhesive layer. From the composite, the portion including the functional pattern was cut out in a size of 5 cm $\times$ 10 cm. Thus fabricated was a transfer film for firing of Example 9.

(Fabrication of Substrate with Functional Pattern)

A substrate with a functional pattern was fabricated by the following procedure.
As the substrate, the same glass plate as in Example 6 was prepared.
A glass plate to which the laminate including a functional pattern was transferred was fabricated by the same method as in Example 6, except that the second peelable film was peeled off from the transfer film for firing.
Then, the glass plate to which the laminate including the functional pattern was transferred was fired under the same firing conditions as in Example 6. Thus fabricated was a glass plate with the functional pattern.

(Comparative Example 9)

A transfer film for firing of Comparative Example 9 was fabricated by the same method as in Example 9, except that, for the first adhesive layer paste and the second adhesive layer paste, the same polybutyral resin "BL-S" (manufactured by Sekisui Chemical Co., Ltd., pyrolysis completion temperature: 435˚C) as in Comparative Example 7 was used.
A glass plate to which the laminate including a functional pattern was transferred was fabricated by the same method as in Example 9.
Then, under the same firing conditions as in Example 9, a glass plate with the functional pattern was fabricated.

(Assessment)

Table 3 shows the pyrolysis completion temperatures of the organic materials contained in the adhesive layer and the functional pattern contained in the transfer film for firing, and the assessment of the fired bodies of the functional patterns, in Example 9 and Comparative Example 9.

The appearance of the fired body of the functional pattern in Example 9 was such that none of unevenness in color, floating, cracks and peeling-off was observed, and received a favorable assessment. In contrast, the appearance of the fired body of the functional pattern in Comparative Example 9 was such that breakage such as unevenness in color, floating, cracks and peeling-off occurred, and did not receive a favorable assessment.

[Table 8]

|  | Pyrolysis completion temperature of organic materials (˚C) | | Assessment |
|---|---|---|---|
|  | 1st and 2nd adhesive layers | Functional pattern |  |
| Example 9 | 350 | 425 | ○ |
| Comparative Example 9 | 435 | 425 | × |

(Comparison)

Examples 6 and 8 are compared with Example 9.

First, comparison is made of the influence of the solvent contained in each layer.

By the production method of the transfer film for firing in each of Example 6 and Example 8, the functional pattern was printed on the (first) adhesive layer. Thus, even when the solvent contained in the (first) adhesive layer is sufficiently vaporized, and then the functional pattern is printed, the (first) adhesive layer may dissolve in the solvent contained in the functional pattern, depending on the combination of the organic material contained in the (first) adhesive layer and the solvent contained in the functional pattern. This may affect the functional pattern, causing distortion or the like. In contrast, by the production method of the transfer film for firing in Example 9, first, the functional pattern was formed on the second peelable film, and then the solvent contained in this functional pattern was sufficiently vaporized. Thereafter, the second adhesive layer was formed on the functional pattern. It is conceivable that, as a result of this, the first adhesive layer did not dissolve in the solvent contained in the functional pattern, and hence the distortion in the functional pattern was successfully minimized. Moreover, it is conceivable that, even when the functional pattern formed on the second peelable film and being in a state where the solvent is sufficiently vaporized, and the first adhesive layer formed on the second adhesive layer and the first peelable film and being in a state where the solvent is sufficiently vaporized are overlapped with each other, and pasted with each other with application of heat and pressure, the dissolution between the functional pattern and the first adhesive layer will not occur.

Next, comparison is made of the smoothness of the functional patterns.

It is conceivable that, in the production method of the transfer film for firing in each of Example 6 and Example 8, the shape and the surface smoothness of the functional pattern in contact with.the surface of the glass plate depended on the coating method or printing method of the adhesive layers or the functional pattern. In contrast, by the production method of the transfer film for firing in Example 9, the functional pattern was directly formed on the second peelable film, and thus the surface of the functional pattern in contact with the surface of the glass plate was flat. It is conceivable that the smoothness of the surface of the functional pattern depended on the smoothness of the second peelable film. Hence, it is conceivable that a surface of the functional pattern which was excellent in close-contact properties to the surface of the glass was successfully formed.

The comparison of these shows that the production method of a transfer film for firing in Example 9 makes it possible to reduce the influence by the solvent contained in the layers, and to form a functional pattern having excellent close-contact properties to the glass.

(Comparative Example 10)

A transfer film for firing of Comparative Example 10 was fabricated using the same materials and the same apparatuses as in Example 6, except that the stacking order of a laminate including a functional pattern was reversed to the stacking order in Example 6.

Then, a glass plate to which the laminate including a functional pattern was transferred was fabricated by the same method as in Example 6. The transferred laminate had a structure including the adhesive layer between the functional pattern and the glass plate. Under the same firing conditions as in Example 6, a glass plate with a functional pattern was fabricated.

(Assessment)

Table 4 shows the pyrolysis completion temperatures of the organic materials contained in the adhesive layer and the functional pattern of the transfer film for firing, and assessment of each fired body of the functional pattern, in Comparative Example 10.

The fired body of the functional pattern in Comparative Example 10 had cracks and was fractured, and hence was unfavorable. The pyrolysis completion temperature of the adhesive layer, which was a lower layer, was lower than the pyrolysis completion temperature of the organic material contained in the functional pattern at a layer over the adhesive layer. Hence, it is conceivable that the pressure due to the pyrolysis-gas generated from the adhesive layer fractured the functional pattern.

[Table 9]

|  | Pyrolysis completion temperature of organic materials (˚C) | | Assessment |
|---|---|---|---|
|  | adhesive layer (lower layer) | Functional pattern (upper layer) | |
| Comparative Example 10 | 350 | 425 | × |

(Comparison)

Example 6 is compared with Comparative Example 10.

The layers in the laminate including the functional pattern of Comparative Example 10 were formed in the reversed order to that of the laminate including the functional pattern of Example 6. For the laminate transferred to the surface of the glass plate in Comparative Example 10, the functional pattern having a high pyrolysis completion temperature was formed on the adhesive layer having a low pyrolysis completion temperature. Accordingly, it is conceivable that the pressure due to the pyrolysis-gas which was from the adhesive layer, and which was obstructed by the functional pattern at the upper layer caused the defects in the fired body of the functional pattern.

The comparison shows that, to obtain a favorable fired body of a functional pattern, it is necessary that the relation that the pyrolysis completion temperature of an upper layer is lower than the pyrolysis completion temperature of a lower layer be satisfied, irrespective of the function of the layers in the laminate which is transferred to a surface of a glass plate.

BRIEF DESCRIPTION OF THE DRAWINGS

[Fig. 1] Fig. 1 is an enlarged schematic sectional diagram illustrating a transfer film for firing according to one embodiment of the present invention.

[Fig. 2] Fig. 2 is an enlarged schematic sectional diagram illustrating a transfer film for firing according to another embodiment of the present invention.

[Fig. 3] Fig. 3 is an enlarged schematic sectional diagram illustrating a transfer film for firing according to still another embodiment of the present invention.

[Fig. 4] Fig. 4 is an enlarged schematic sectional diagram illustrating a transfer film for firing according to a different embodiment of the present invention.

[Fig. 5] Fig. 5 is an enlarged schematic sectional diagram illustrating a transfer film for firing of another different embodiment of the present invention.

[Fig. 6] Fig. 6 is an enlarged schematic sectional diagram illustrating a transfer film for firing of still another different embodiment of the present invention.

[Fig. 7] Fig. 7 is an enlarged schematic sectional diagram illustrating a configuration of the transfer film for firing according to one embodiment of the present invention.

[Fig. 8] Fig. 8 is a schematic plan diagram illustrating the configuration of the transfer film for firing according to the embodiment of the present invention.

[Fig. 9] Fig. 9 is an enlarged schematic sectional diagram illustrating a configuration of the transfer film for firing after transfer according to the embodiment of the present invention.

[Fig. 10] Fig. 10 is an enlarged schematic sectional diagram illustrating a configuration of a transfer film for firing according to another embodiment of the present invention.

EXPLANATION OF REFERENCE NUMERALS

1    Peelable film (first peelable film)
2    Functional pattern
3    Sticking layer
4    Intermediate layer
5    Protective layer
6    Second peelable film
11   (First) peelable film
12   (First) adhesive layer
13   Functional pattern
14   Substrate
15   Second adhesive layer
16   Second peelable film

**Claims**

1.  A transfer film for firing used for forming a fired body of a functional pattern by transferring a laminate including the functional pattern to a surface of a substrate, followed by firing, the transfer film for firing **characterized in that** the transfer film for firing comprises:

    a peelable film; and
    the laminate formed so as to be in contact with one surface of the peelable film,

    the laminate further comprises:

    a sticking layer for pasting the transfer film for firing on the surface of the substrate; and
    a functional pattern formed between the peelable film and the sticking layer,

    the functional pattern contains

    an inorganic powder and a first organic material removable by firing, and
    the sticking layer contains a second organic material which is removable by firing and different from the first organic material, and

    under a firing condition for firing the laminate transferred to the surface of the substrate, a pyrolysis temperature ($Tdb$) of the first organic material, a pyrolysis temperature ($Tda$) of the second organic material, and a fusion temperature($Tw$) of the inorganic powder satisfy a relation of:

$$Tdb < Tda < Tw.$$

2.  The transfer film for firing according to claim 1,
    **characterized in that**
    the laminate comprises an intermediate layer formed between the functional pattern and the sticking layer, and
    under the firing condition, the pyrolysis temperature ($Tdb$) of the first organic material, a pyrolysis temperature ($Tdm$) of the second organic material, the pyrolysis temperature ($Tda$) of the organic material contained in the sticking layer, and the fusion temperature ($Tw$) of the inorganic powder satisfy a relation of: $Tdb < Tdm < Tda < Tw$.

3.  The transfer film for firing according to claim 1 or 2,
    **characterized in that**
    the laminate comprises a protective layer which protects the functional pattern and which is formed between the peelable film and the functional pattern,
    the protective layer contains a third organic material which is removable by firing and different from the first organic material, and
under the firing condition, a pyrolysis temperature (Tdp) of the third organic material and the pyrolysis temperature (Tdb) of the first organic material satisfy a relation of: Tdp < Tdb.

4. The transfer film for firing according to any of claims 1 to 3, **characterized in that**
under the firing condition, a maximum value of a generation rate of a pyrolysis gas from the organic material contained in the sticking layer is less than 5 wt%/sec, based on an initial weight of the organic material contained in the sticking layer.

5. A method of forming a substrate with a functional pattern by transferring a laminate including the functional pattern to a surface of a substrate, followed by firing, the method **characterized by** comprising:

pasting the transfer film for firing according to any of claims 1 to 4 on a surface of the substrate with the sticking layer interposed therebetween and then peeling off the peelable film of the transfer film for firing, thereby forming a substrate to which the laminate including a functional pattern is transferred; and
firing the substrate to which the laminate is transferred under such a firing condition that the organic materials contained in the laminate are pyrolyzed sequentially in order from the farthest organic material from the surface of the substrate.

6. The method of forming a substrate with a functional pattern according to claim 4, **characterized in that** the firing condition is such that a maximum value of a generation rate of a pyrolysis gas from the organic material contained in the sticking layer is less than 5 wt%/sec, based on an initial weight of the organic material contained in the sticking layer.

7. A transfer film for firing used for forming a fired body of a functional pattern by transferring a laminate including the functional pattern to a surface of a substrate, followed by firing, the transfer film for firing **characterized in that**
the transfer film for firing comprises:

a peelable film; and
the laminate formed on the peelable film,

the laminate comprises:

a functional pattern; and
at least one adhesive layer which is bonded to the surface of the substrate when the laminate is transferred to the substrate,
the functional pattern contains an inorganic powder and an organic material removable by firing,
the adhesive layer contains an organic material removable by firing, and
a pyrolysis completion temperature of the organic material contained in the adhesive layer located between the functional pattern and the peelable film is lower than a pyrolysis completion temperature of the organic material contained in the functional pattern.

8. The transfer film for firing according to claim 7, **characterized in that** one of a glass transition temperature and a softening temperature of the organic material contained in the adhesive layer is 50°C or above but 150°C or below.

9. A method of forming a substrate with a functional pattern by transferring a laminate to a surface of a substrate, followed by firing, the method **characterized by** comprising:

pasting the transfer film for firing according to claim 7 or 8 the surface of the substrate with the adhesive layer interposed therebetween and then peeling off the peelable film of the transfer film for firing, thereby forming a substrate to which the laminate including a functional pattern is transferred, and
firing the substrate under such a firing condition that, after the pyrolysis of the organic material contained in the adhesive layer is completed, the pyrolysis of the organic material contained in the functional pattern is completed.

10. A method of forming a substrate with a functional pattern by transferring a laminate to a surface of a substrate, followed by firing, the method **characterized by** comprising:

heating the transfer film for firing according to claim 7 or 8 to a temperature which is not less than a glass transition temperature or a softening temperature of the organic material contained in the adhesive layer;
pasting the heated transfer film for firing on the surface of the substrate in a way that the functional pattern comes into contact with the substrate and then peeling off the peelable film of the transfer film for firing, thereby forming a substrate to which the laminate including a functional pattern is transferred; and
firing the substrate under such a firing condition that, after the pyrolysis of the organic material contained in the adhesive layer is completed, the pyrolysis of the organic material contained in the functional pattern is completed.

11. The method of forming a substrate with a functional pattern according to claim 10, **characterized in that**
the temperature to which the transfer film for firing is heated is 50°C or above but 150°C or below.

# FIG.1

# FIG.2

# FIG.3

# FIG.4

## FIG.5

## FIG.6

## FIG.7

# FIG.8

# FIG.9

# FIG.10

<table>
<tr><td colspan="2" align="center">**INTERNATIONAL SEARCH REPORT**</td><td>International application No.<br>PCT/JP2008/060868</td></tr>
</table>

| | |
|---|---|
| A. CLASSIFICATION OF SUBJECT MATTER<br>*B44C1/165(2006.01)i, B44C1/17(2006.01)i* | |

According to International Patent Classification (IPC) or to both national classification and IPC

B. FIELDS SEARCHED

Minimum documentation searched (classification system followed by classification symbols)
B44C1/165, B44C1/17

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2000-151080 A  (Asahi Glass Co., Ltd.),<br>30 May, 2000 (30.05.00),<br>Claim 7; examples<br>& EP 1156709 A1        & WO 2001/019147 A1 | 1,4-6<br>3<br>8,11 |
| Y<br>A | JP 10-29400 A  (NGK Spark Plug Co., Ltd.),<br>03 February, 1998 (03.02.98),<br>Claim 3; Par. No. [0015]<br>& US 5976674 A        & EP 802071 A1<br>& DE 69702367 T        & BR 9702582 A | 3<br>8,11 |
| X<br>A | JP 57-142385 A  (Toyobo Co., Ltd.),<br>03 September, 1982 (03.09.82),<br>Examples 1 to 4<br>(Family: none) | 7,9,10<br>8,11 |

☐ Further documents are listed in the continuation of Box C.    ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>28 August, 2008 (28.08.08) | Date of mailing of the international search report<br>09 September, 2008 (09.09.08) |
| Name and mailing address of the ISA/<br>Japanese Patent Office | Authorized officer |
| Facsimile No. | Telephone No. |

Form PCT/ISA/210 (second sheet) (April 2007)

## INTERNATIONAL SEARCH REPORT

| International application No. |
|---|
| PCT/JP2008/060868 |

**Box No. II      Observations where certain claims were found unsearchable (Continuation of item 2 of first sheet)**

This international search report has not been established in respect of certain claims under Article 17(2)(a) for the following reasons:

1. ☐   Claims Nos.:
     because they relate to subject matter not required to be searched by this Authority, namely:

2. ☒   Claims Nos.: 2
     because they relate to parts of the international application that do not comply with the prescribed requirements to such an
     extent that no meaningful international search can be carried out, specifically:
   Claim 2 includes the term "heat decomposition temperature ($Tdm$) of the second
 organic substance" and the term "heat decomposition temperature ($Tda$) of
 the organic substance contained in the <u>pressure-sensitive adhesive layer</u>."
 (continued to extra sheet)

3. ☐   Claims Nos.:
     because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
   See extra sheet.

1. ☒   As all required additional search fees were timely paid by the applicant, this international search report covers all searchable
     claims.

2. ☐   As all searchable claims could be searched without effort justifying additional fees, this Authority did not invite payment of
     additional fees.

3. ☐   As only some of the required additional search fees were timely paid by the applicant, this international search report covers
     only those claims for which fees were paid, specifically claims Nos.:

4. ☐   No required additional search fees were timely paid by the applicant.    Consequently, this international search report is
     restricted to the invention first mentioned in the claims; it is covered by claims Nos.:

**Remark on Protest**
the

☐   The additional search fees were accompanied by the applicant's protest and, where applicable,
     payment of a protest fee.

☐   The additional search fees were accompanied by the applicant's protest but the applicable protest
     fee was not paid within the time limit specified in the invitation.

☒   No protest accompanied the payment of additional search fees.

Form PCT/ISA/210 (continuation of first sheet (2)) (April 2007)

| **INTERNATIONAL SEARCH REPORT** | International application No. |
|---|---|
| | PCT/JP2008/060868 |

<u>Continuation of Box No.II-2 of continuation of first sheet(2)</u>

However, claim 1, on which claim 2 depends, includes a statement to the effect that "the <u>pressure-sensitive adhesive layer</u> contains a second organic substance" and further includes the term "heat decomposition temperature of the second organic substance (<u>Tda</u>)." Consequently, the relationship between the heat decomposition temperatures in claim 2 is unclear. Claim 2 hence does not comply with the requirement of clearness as provided for in Article 6 of the PCT.

<u>Continuation of Box No.III of continuation of first sheet(2)</u>

1. The subject matter of claims 1 and 3-6 is a transfer film for burning which is for use in forming a burned functional pattern by transferring a multilayered structure including a functional pattern to a surface of a substrate and burning it, characterized in that it comprises a release film and the multilayered structure formed so as to be in contact with one of the surfaces of the release film, that the multilayered structure includes both a pressure-sensitive adhesive layer for bonding the transfer film for burning to a surface of the substrate and a functional pattern formed between the release film and the pressure-sensitive adhesive layer, that the functional pattern comprises inorganic particles and a first organic substance removable by burning, that the pressure-sensitive adhesive layer comprises a second organic substance removable by burning and different from the first organic substance, and that the heat decomposition temperature of the first organic substance (Tdb), the heat decomposition temperature of the second organic substance (Tda), and the fusion bonding temperature of the inorganic particles (Tw) each measured under the burning conditions to be used for burning the multilayered structure transferred to a surface of a substrate satisfy the relationship Tdb<Tda<Tw.

2. The subject matter of claims 7-11 is a transfer film for burning which is for use in forming a burned functional pattern by transferring a multilayered structure including a functional pattern to a surface of a substrate and burning it, characterized in that it comprises a release film and the multilayered structure formed on the release film, that the multilayered structure includes a functional pattern and at least one adhesive layer to be bonded to the substrate surface when the multilayered structure is transferred to the substrate, that the functional pattern comprises inorganic particles and an organic substance removable by burning, and the adhesive layer comprises an organic substance removable by burning, and that the organic substance contained in the adhesive layer, which is located between the functional pattern and the release film, has a lower heat decomposition completion temperature than the organic substance contained in the functional pattern.

Form PCT/ISA/210 (extra sheet) (April 2007)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05139020 B
- JP H11135009 B
- JP H11260250 B
- JP 2001211020 A
- JP 2000151080 A